(19) Europäisches Patentamt
European Patent Office
Office européen des brevets

(11) EP 2 629 424 A1

(12) EUROPEAN PATENT APPLICATION
published in accordance with Art. 153(4) EPC

(43) Date of publication:
21.08.2013 Bulletin 2013/34

(51) Int Cl.:
H03L 7/087 (2006.01)     H03L 7/08 (2006.01)
H03L 7/085 (2006.01)     H03L 7/095 (2006.01)
H03L 7/197 (2006.01)

(21) Application number: 11864036.6

(22) Date of filing: 19.04.2011

(86) International application number:
PCT/JP2011/002283

(87) International publication number:
WO 2012/143970 (26.10.2012 Gazette 2012/43)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(71) Applicant: Mitsubishi Electric Corporation
Tokyo 100-8310 (JP)

(72) Inventors:
• TAJIMA, Kenichi
  Tokyo 100-8310 (JP)

• NAKAMIZO, Hideyuki
  Tokyo 100-8310 (JP)
• HIEDA, Morishige
  Tokyo 100-8310 (JP)

(74) Representative: Pfenning, Meinig & Partner GbR
Patent- und Rechtsanwälte
Theresienhöhe 13
80339 München (DE)

(54) FREQUENCY SYNTHESIZER

(57) A phase difference detecting circuit 3 includes a sync detecting circuit 21 for detecting establishment of phase sync from phase difference signals D and U generated by a D-type flip-flop 13, and a switch 22 for supplying, unless the sync detecting circuit 21 detects the establishment of the phase sync, the control voltage $V_{t1}$ generated by the current-output-matching loop filter 15 to a voltage-controlled oscillator 4, and for supplying, when the sync detecting circuit 21 detects the establishment of the phase sync, the control voltage $V_{t2}$ generated by the voltage-output-matching loop filter 20 to the voltage-controlled oscillator 4.

FIG.1

EP 2 629 424 A1

**Description**

TECHNICAL FIELD

The present invention relates to a fractional-Nphase-locked loop frequency synthesizer used for a radio communication apparatus, for example.

BACKGROUND ART

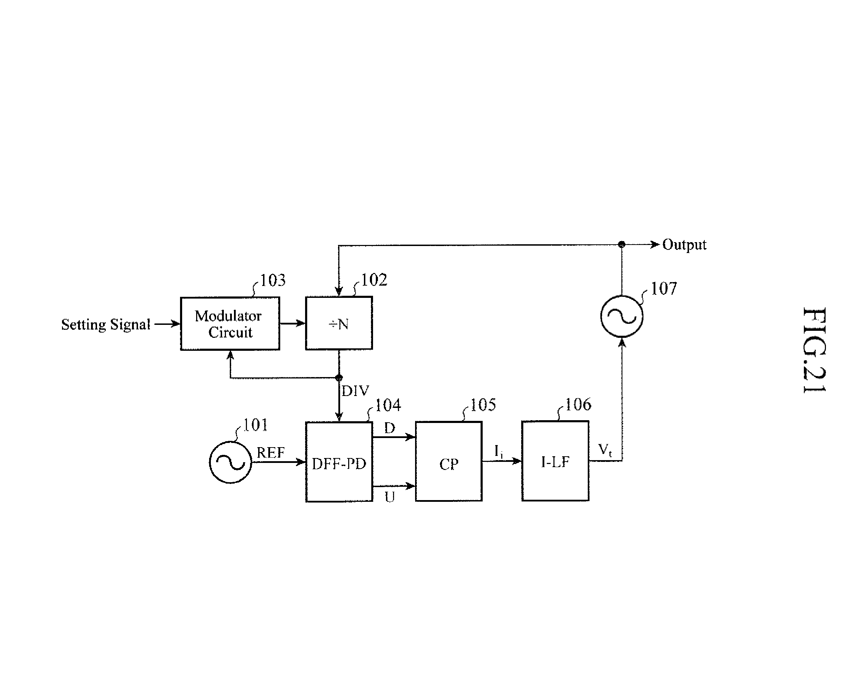

FIG. 21 is a block diagram showing a configuration of a fractional-N phase-locked loop frequency synthesizer disclosed in the following Non-Patent Document 1.
The operation of the frequency synthesizer of FIG. 21 will be described below.
A reference signal source 101 generates a reference signal REF and supplies the reference signal REF to a phase comparator 104.
A variable frequency divider 102 (denoted by "÷ N" in FIG. 21) divides the high-frequency signal output from a voltage-controlled oscillator 107 in accordance with the division data output from a modulator circuit 103, and supplies the high-frequency signal after the division to the phase comparator 104 as a sync signal DIV.
The modulator circuit 103 operates in sync with the reference signal generated by the reference signal source 101 or with the sync signal supplied from the variable frequency divider 102, determines the number of divisions of the variable frequency divider 102 in response to the setting signal fed from the outside, and supplies division data indicating the number of divisions to the variable frequency divider 102.
The phase comparator 104 (designated by "DFF-PD" in FIG. 21), which is composed of a D-type flip-flop, supplies a charge pump 105 with phase difference signals D and U corresponding to the phase difference between the reference signal REF output from the reference signal source 101 and the sync signal DIV supplied from the variable frequency divider 102.
The charge pump 105 (designated by "CP" in FIG. 21) supplies a current-output-matching loop filter 106 with a charge pump current $I_i$ corresponding to the phase difference signals D and U supplied from the phase comparator 102.
The current-output-matching loop filter 106 (denoted by "I-LF" in FIG. 21) supplies the voltage obtained by smoothing the charge pump current $I_i$ supplied from the charge pump 105 to the voltage-controlled oscillator 107 as control voltage $V_t$.
The voltage-controlled oscillator 107, receiving the control voltage $V_t$ from the current-output-matching loop filter 106, generates the high-frequency signal with a frequency corresponding to the control voltage $V_t$, and supplies the high-frequency signal to the variable frequency divider 102 and outputs it to the outside.

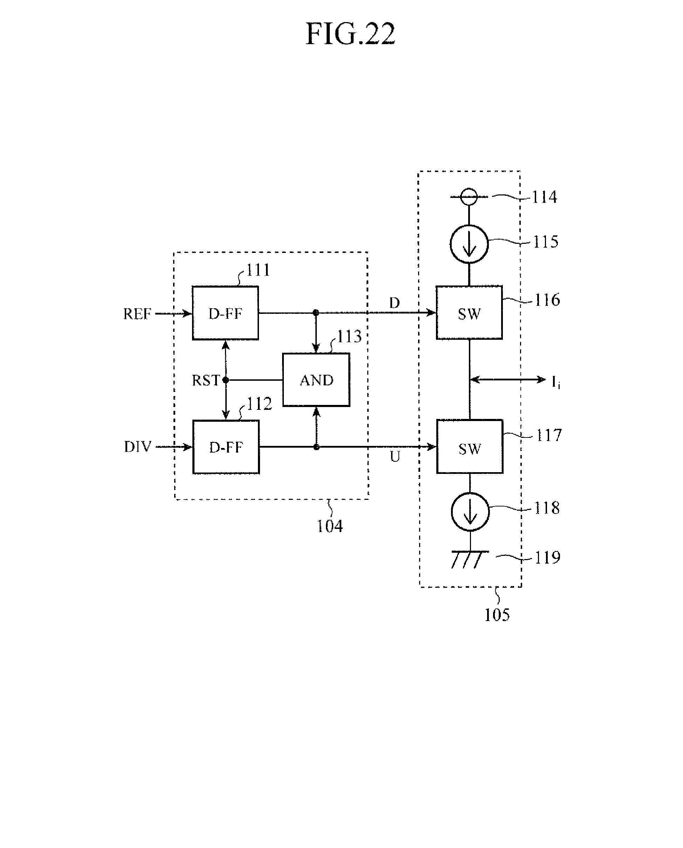

FIG. 22 is a block diagram showing an internal configuration of the phase comparator 104 and charge pump 105 in the frequency synthesizer.
The operation of the phase comparator 104 and charge pump 105 will be described below.
A D-type flip-flop 111 of the phase comparator 104 (designated by "D-FF" in FIG. 22) receives the reference signal REF output from the reference signal source 101 and the reset signal RST, and supplies the leading edge detection signal D of the reference signal REF to an AND circuit 113 and a switch 116 of the charge pump 105.
A D-type flip-flop 112 (designated by "D-FF" in FIG. 22) receives the sync signal DIV supplied from the variable frequency divider 102 and the reset signal RST, and supplies the leading edge detection signal U of the sync signal DIV to the AND circuit 113 and a switch 117 of the charge pump 105.
The AND circuit 113 (designated by "AND" in FIG. 22) receives the leading edge detection signal D supplied from the D-type flip-flop 111 and the leading edge detection signal U supplied from the D-type flip-flop 112, performs the AND operation for the leading edge detection signal D and leading edge detection signal U, and supplies the operation result to the D-type flip-flops 111 and 112 as the reset signal RST.
A constant-current source 115 of the charge pump 105 is connected to a power supply circuit 114 and generates the prescribed current $I_i$.
A constant-current source 118 is connected to a ground terminal 119, generates the prescribed current $I_i$ and delivers the current $I_i$ toward the ground terminal 119.
The switch 116 (designated by "SW" in FIG. 22) is brought to the ON state when it receives the leading edge detection signal D from the D-type flip-flop 111 of the phase comparator 104.
The switch 117 (designated by "SW" in FIG. 22) is brought to the ON state when it receives the leading edge detection signal U from the D-type flip-flop 112 of the phase comparator 104.

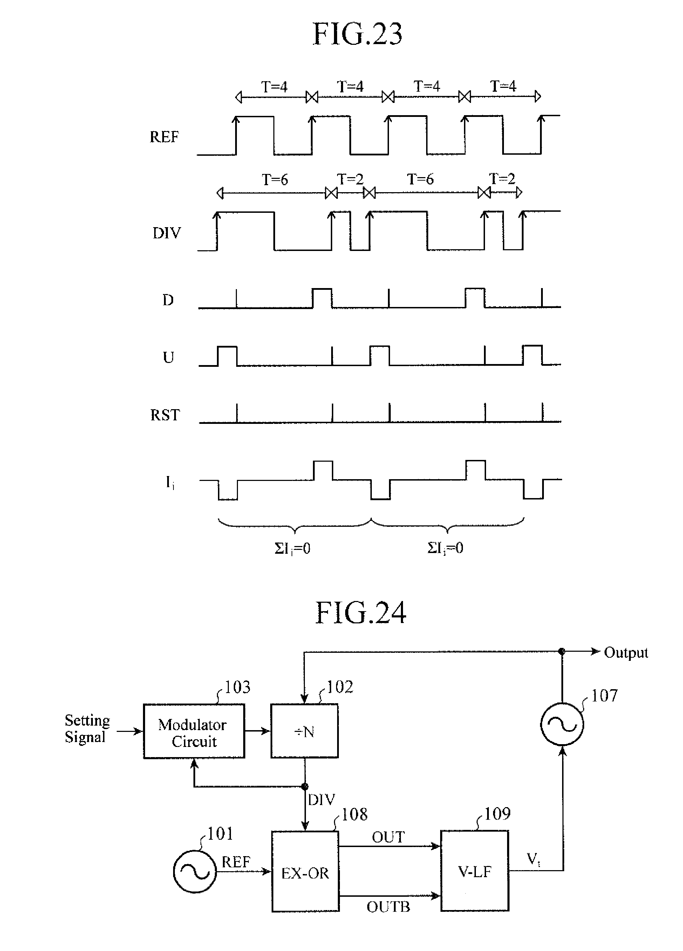

FIG. 23 is a diagram illustrating waveforms of various portions of the phase comparator 104 and the charge pump 105 when the period T of the reference signal REF is "4" and the period T of the sync signal DIV is a repetition of "6" and "2".
For example, when the leading edge of the sync signal DIV arrives ahead of the reference signal REF, only the leading edge detection signal U changes from logic low to logic high.

Then at the time when the leading edge of the reference signal REF is detected, the leading edge detection signal D changes from logic low to logic high.

At this time, since the reset signal RST changes from logic low to logic high, the D-type flip-flops 111 and 112 are reset and the leading edge detection signals U and D change to logic low.

While the leading edge detection signal U is logic high, the switch 117 becomes ON state so that the current $I_i$ flows from the outside toward the ground terminal 119. In this case, since the charge pump 105 sucks the current from the outside to the inside, the direction of the current $I_i$ is negative.

When the leading edge of the reference signal REF arrives ahead of the sync signal DIV, only the leading edge detection signal D changes from logic low to logic high.

Then at the time when the leading edge of the sync signal DIV is detected, the leading edge detection signal U changes from logic low to logic high.

At this time, since the reset signal RST also changes from logic low to logic high, the D-type flip-flops 111 and 112 are reset and the leading edge detection signals U and D change to logic low.

While the leading edge detection signal D is logic high, the switch 116 becomes ON state so that the current $I_i$ flows from the power supply circuit 114 toward the outside. In this case, the direction of the current $I_i$ is positive.

Thus, the frequency synthesizer using the phase comparator 104 comprising the D-type flip-flops 111 and 112 handles the time difference between the leading edges of the reference signal REF and of the sync signal DIV as the phase difference between the reference signal REF and the sync signal DIV.

Then, according to the current $I_i$ corresponding to the phase difference between the reference signal REF and the sync signal DIV, the current-output-matching loop filter 106 supplies the control voltage $V_t$ to the voltage-controlled oscillator 107 so as to set the high-frequency signal generated from the voltage-controlled oscillator 107 at a desired frequency.

Once the phase sync has been established, the integrated result of the current $I_i$ over one period of a division number pattern that changes with respect to time becomes zero ideally and the control voltage $V_t$ is maintained at a prescribed voltage.

Incidentally, to make the integrated result zero, it is necessary for the current-output-matching loop filter 106 to have infinite DC gain. In practice, however, although the DC gain is not infinite, since it is very large, the integrated result becomes nearly zero.

FIG. 24 is a block diagram showing a configuration of a phase-locked loop frequency synthesizer disclosed in the following Non-Patent Document 2.

The frequency synthesizer of FIG. 24 uses a phase comparator 108 comprising an EX-OR circuit.

The operation of the frequency synthesizer of FIG. 24 will be described.

In FIG. 24, since the same reference numerals as those of the frequency synthesizer of FIG. 21 designate the same or like components, their description will be omitted.

The phase comparator 108 consisting of the EX-OR circuit (designated by "EX-OR" in FIG. 24) receives the reference signal REF output from the reference signal source 101 and the sync signal DIV output from the variable frequency divider 102, and supplies a voltage-output-matching loop filter 109 with phase difference signals OUT and OUTB corresponding to the phase difference between the reference signal REF and the sync signal DIV. Incidentally, OUTB and OUT are a pair of a differential signal.

The voltage-output-matching loop filter 109 (designated by "V-LF" in FIG. 24) supplies the voltage obtained by smoothing the phase difference signals OUT and OUTB supplied from the phase comparator 108 to the voltage-controlled oscillator 107 as the control voltage $V_t$.

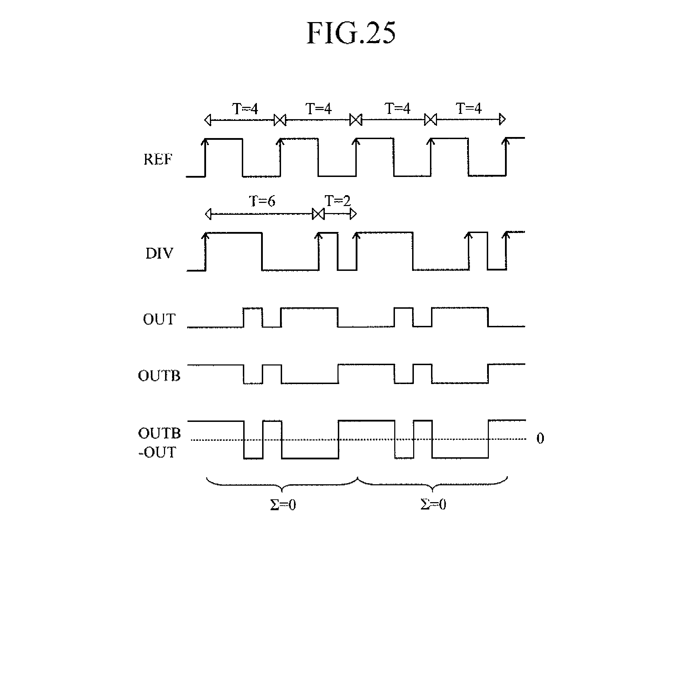

FIG. 25 is a diagram illustrating waveforms of various portions of the phase comparator 108 (EX-OR circuit) when the period T of the reference signal REF is "4" and the period T of the sync signal DIV is a repetition of "6" and "2".

As for the phase comparator 108 which is the EX-OR circuit, when both the input signals, the reference signal REF and the sync signal DIV, have the same state (both the signals are logic high or logic low), the phase difference signal OUT is logic low and the phase difference signal OUTB is logic high.

On the other hand, when the input signals, the reference signal REF and the sync signal DIV, have different states (logic high and logic low), the phase difference signal OUT is logic high and the phase difference signal OUTB is logic low.

Incidentally, the difference signal OUTB - OUT becomes a voltage signal with zero as its center.

Thus, the frequency synthesizer employing the phase comparator 108 consisting of the EX-OR circuit handles the time difference between the states (logic high or logic low) of the reference signal REF and sync signal DIV as the phase difference between the reference signal REF and the sync signal DIV.

Then, according to the difference signal (OUTB - OUT) corresponding to the phase difference between the reference signal REF and the sync signal DIV, the voltage-output-matching loop filter 109 supplies the control voltage $V_t$ to the voltage-controlled oscillator 107 so as to set the high-frequency signal generated from the voltage-controlled oscillator 107 at a desired frequency.

Once the phase sync has been established, the integrated result of the difference signal (OUTB - OUT) over one period of a division number pattern that changes with respect to time becomes zero ideally and the control voltage $V_t$ is maintained at a prescribed voltage.

Incidentally, to make the integrated result zero, it is necessary for the voltage-output-matching loop filter 109 to have infinite DC gain. In practice, however, although the DC gain is not infinite, since it is very large, the integrated result becomes nearly zero.

Comparing the phase comparator 104 comprising the D-type flip-flops 111 and 112 with the phase comparator 108 consisting of the EX-OR circuit, in the phase comparator 104, the detection signals output from the D-type flip-flops 111 and 112 vary in response to the phase difference between the input signals.

On the other hand, in the EX-OR circuit, since it consists of a single circuit, the operational position for the phase difference between the input signals does not vary.

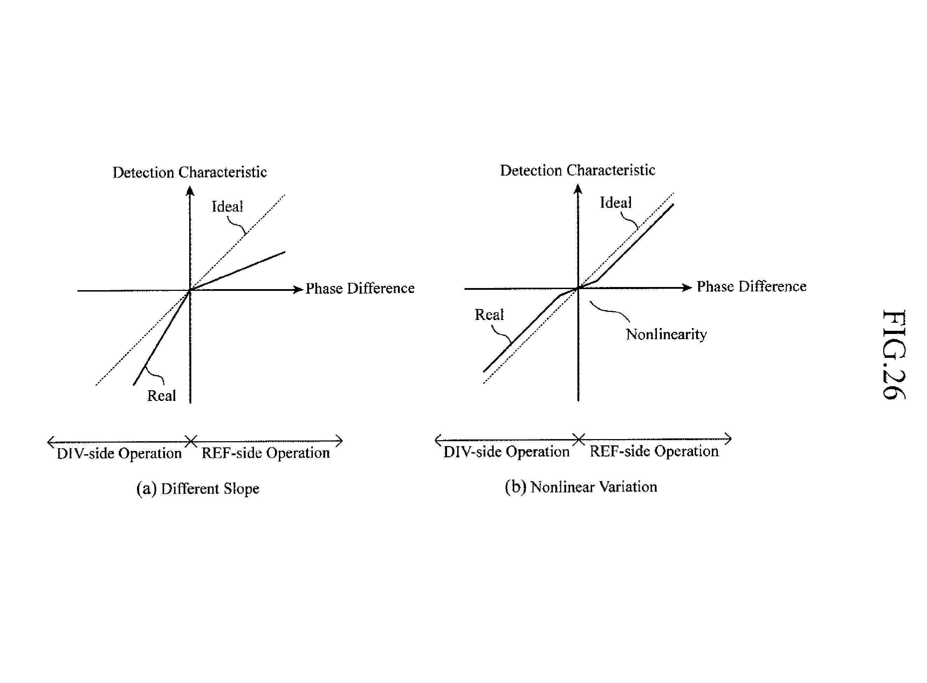

FIG. 26 is a diagram illustrating detection characteristics of the phase difference when the phase comparator 104 is composed of the D-type flip-flops 111 and 112.

Ideally, the detection characteristics against the phase difference become linear (the detection characteristics denoted by a dotted line). However, difference in the slope of the detection characteristics can occur owing to variations in the currents of the constant-current sources 115 and 118 or error factors such as delay of operation timing between the circuits in the D-type flip-flops 111 and 112. In addition, nonlinear changes in the phase difference can occur in the neighborhood of zero.

When the phase comparator 104 is composed of the D-type flip-flops 111 and 112, since the phase difference between the reference signal REF and the sync signal DIVmostly takes a negative or positive value depending on the number of divisions, the D-type flip-flops 111 and 112 that produce the detection signal change and are affected by the nonlinearity of the detection characteristics as shown in FIG. 26.

As a result, spurious emission can occur in the high-frequency signal which is the output of the frequency synthesizer. In addition, when the spurious emission is in the neighborhood of a carrier wave, the out-of-band suppression effect due to the closed loop transfer characteristics of the PLL cannot be achieved.

When using the phase comparator 108 consisting of the EX-OR circuit, spurious emission caused by the variations between the circuits in the D-type flip-flops 111 and 112 does not occur.

However, even when using the phase comparator 108 consisting of the EX-OR circuit, spurious emission can occur because of other factors.

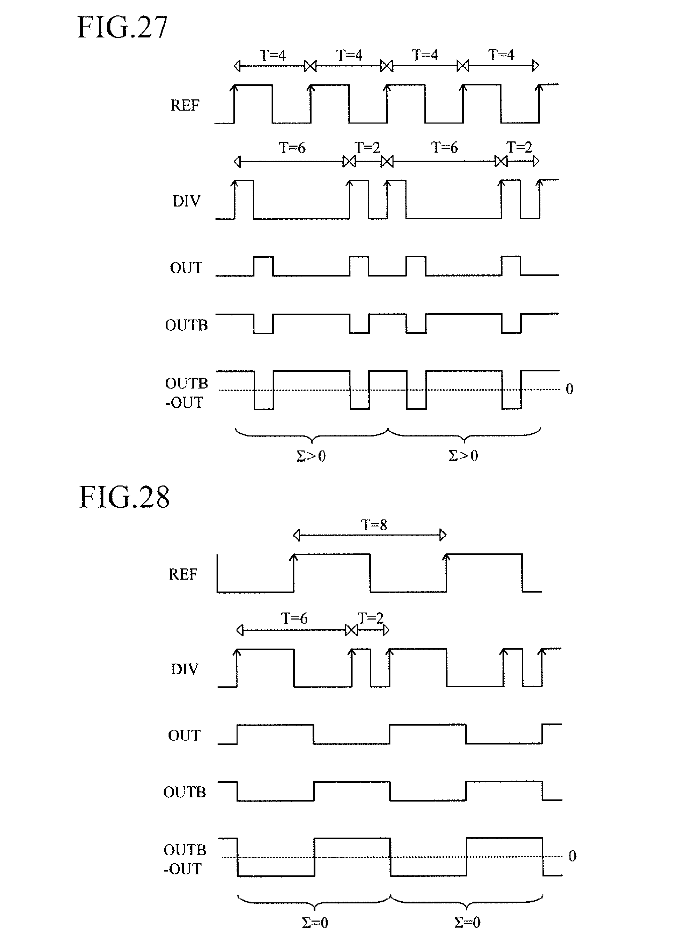

FIG. 27 is a diagram illustrating waveforms of various portions of the EX-OR circuit when the reference signal REF and sync signal DIV with the same leading edges as those of FIG. 25 are supplied.

FIG. 27 differs from FIG. 25 in the duty factor of the waveform of the sync signal DIV whose period T is "6".

It is found from FIG. 27 that the integrated result of the difference signal (OUTB - OUT) over one period of the time varying pattern is greater than zero. More specifically, over the period T of "8", the difference signal (OUTB - OUT) is placed at logic high during the period T of "6" and logic low during the period T of "2".

Thus, when using the phase comparator 108 consisting of the EX-OR circuit, the comparison result of the phase comparator 108 varies depending on the duty factor of the input signal. As a result, spurious emission occurs in the high-frequency signal which is the output of the frequency synthesizer.

FIG. 28 is a diagram illustrating waveforms of various portions of the phase comparator 108 (EX-OR circuit) when the period T of the reference signal REF is "8" and the period T of the sync signal DIV is a repetition of "6" and "2".

The average of the period T of the sync signal DIV is "4" which differs from the period T of "8" of the reference signal REF. However, the integrated result of the difference signal (OUTB - OUT) over one period of the time varying pattern becomes zero as in FIG. 25, which means that the phase sync is established. In other words, the phase comparator 108 consisting of the EX-OR circuit cannot achieve broadband frequency control.

PRIOR ART DOCUMENT

NON-PATENT DOCUMENT

Non-Patent Document 1: Tsung-Hsien Lin et al., "Dynamic Current-Matching Charge Pump and Gated-Offset Linearization Technique for Delta-Sigma Fractional-N PLLs", IEEE Transactions on Circuits and Systems-I, Vol. 56, No. 5, pp. 877 - 885, May 2009.

Non-Patent Document 2 : Y. Sumi et al., "Dead-zone-less PLL Frequency Synthesizer by Hybrid Phase Detectors", Proceedings of the IEEE Symposium on Circuits and Systems, Vol. 4, pp. 410 - 414, June 1999.

DISCLOSURE OF THE INVENTION

PROBLEMS TO BE SOLVED BY THE INVENTION

With the foregoing configurations, regardless of whether the phase comparator 104 is composed of the D-type flip-flops 111 and 112 or the phase comparator 108 is composed of the EX-OR circuit, the conventional frequency synthesizers have a problem of having spurious emission occurring in the high-frequency signal which is the output.

The present invention is implemented to solve the foregoing problem. Therefore it is an object of the present invention to provide a frequency synthesizer capable of achieving low spurious characteristics.

MEANS TO SOLVE THE PROBLEMS

A frequency synthesizer in accordance with the present invention including a reference signal source for generating a reference signal, a sync signal output circuit for dividing a high-frequency signal and for outputting a high-frequency signal after division as a sync signal, a phase difference detecting circuit for detecting phase difference between the reference signal generated by the reference signal source and the sync signal output from the sync signal output circuit and for outputting control voltage corresponding to the phase difference, and a voltage-controlled oscillator for generating a high-frequency signal with a frequency corresponding to the control voltage output from the phase difference detecting circuit and for outputting the high-frequency signal to the sync signal output circuit and to an outside, wherein the phase difference detecting circuit comprises: a first phase comparator for generating a phase difference signal from detection timing of a signal edge of the reference signal and a signal edge of the sync signal; a first control voltage generating circuit for generating the control voltage corresponding to the phase difference signal generated by the first phase comparator; a first flip-flop for inverting amplitude of its output signal every time it detects a signal edge of the sync signal; an inverter for inverting amplitude of the reference signal; a second flip-flop for inverting amplitude of its output signal every time it detects a signal edge of the reference signal after the amplitude inversion by the inverter; a second phase comparator for performing an exclusive OR operation for output signals of the first and second flip-flops, and for outputting a phase difference signal indicating the operation result; a second control voltage generating circuit for generating control voltage corresponding to the phase difference signal output from the second phase comparator; a sync detecting circuit for detecting establishment of phase sync from the phase difference signal generated by the first phase comparator; and a control voltage selecting unit for supplying, unless the sync detecting circuit detects the establishment of the phase sync, the control voltage generated by the first control voltage generating circuit to the voltage-controlled oscillator, and for supplying, when the sync detecting circuit detects the establishment of the phase sync, the control voltage generated by the second control voltage generating circuit to the voltage-controlled oscillator.

ADVANTAGES OF THE INVENTION

According to the present invention, the phase difference detecting circuit comprises: the first phase comparator for generating a phase difference signal from detection timing of a signal edge of the reference signal and a signal edge of the sync signal; the first control voltage generating circuit for generating the control voltage corresponding to the phase difference signal generated by the first phase comparator; the first flip-flop for inverting amplitude of its output signal every time it detects a signal edge of the sync signal; the inverter for inverting amplitude of the reference signal; a second flip-flop for inverting amplitude of its output signal every time it detects a signal edge of the reference signal after the amplitude inversion by the inverter; the second phase comparator for performing an exclusive OR operation for output signals of the first and second flip-flops, and for outputting a phase difference signal indicating the operation result; a second control voltage generating circuit for generating control voltage corresponding to the phase difference signal output from the second phase comparator; the sync detecting circuit for detecting establishment of phase sync from the phase difference signal generated by the first phase comparator; and the control voltage selecting unit for supplying, unless the sync detecting circuit detects the establishment of the phase sync, the control voltage generated by the first control voltage generating circuit to the voltage-controlled oscillator, and for supplying, when the sync detecting circuit detects the establishment of the phase sync, the control voltage generated by the second control voltage generating circuit to the voltage-controlled oscillator. Accordingly, it has an advantage of being able to achieve low spurious characteristics.

BRIEF DESCRIPTION OF THE DRAWINGS

FIG. 1 is a block diagram showing a configuration of a frequency synthesizer of an embodiment 1 in accordance with the present invention;

FIG. 2 is a diagram illustrating waveforms of various portions of a D-type flip-flop 13 and a charge pump 14 when the period T of the reference signal REF is "4.25" and the period T of the sync signal DIV is a repetition of "4", "4", "4" and "5" ;

FIG. 3 is a diagram illustrating waveforms of various portions of T-type flip-flops 16 and 18 and an EX-OR circuit 19 when the period T of the reference signal REF is "4.25" and the period T of the sync signal DIV is a repetition of "4", "4", "4" and "5";

FIG. 4 is a block diagram showing a configuration of another frequency synthesizer of the embodiment 1 in accordance with the present invention;

FIG. 5 is a block diagram showing a configuration of a frequency synthesizer of an embodiment 2 in accordance with the present invention;

FIG. 6 is a block diagram showing a configuration of another frequency synthesizer of the embodiment 2 in accordance with the present invention;

FIG. 7 is a block diagram showing a configuration of still another frequency synthesizer of the embodiment 2 in accordance with the present invention;

FIG. 8 is a block diagram showing a configuration of still another frequency synthesizer of the embodiment 2 in accordance with the present invention;

FIG. 9 is a block diagram showing a configuration of still another frequency synthesizer of the embodiment 2 in accordance with the present invention;

FIG. 10 is a block diagram showing a configuration of still another frequency synthesizer of the embodiment 2 in accordance with the present invention;

FIG. 11 is a block diagram showing a configuration of a frequency synthesizer of an embodiment 3 in accordance with the present invention;

FIG. 12 is a diagram illustrating detection characteristics against phase difference when using a dead-zone phase comparator 41;

FIG. 13 is a block diagram showing a configuration of another frequency synthesizer of the embodiment 3 in accordance with the present invention;

FIG. 14 is a block diagram showing a configuration of still another frequency synthesizer of the embodiment 3 in accordance with the present invention;

FIG. 15 is a block diagram showing a configuration of still another frequency synthesizer of the embodiment 3 in accordance with the present invention;

FIG. 16 is a block diagram showing a configuration of a frequency synthesizer of an embodiment 4 in accordance with the present invention;

FIG. 17 is a block diagram showing a configuration of another frequency synthesizer of the embodiment 4 in accordance with the present invention;

FIG. 18 is a block diagram showing a configuration of a voltage-output-matching loop filter 20;

FIG. 19 is a block diagram showing a configuration of the voltage-output-matching loop filter 20;

FIG. 20 is a block diagram showing a configuration of the voltage-output-matching loop filter 20;

FIG. 21 is a block diagram showing a configuration of a fractional-N phase-locked loop frequency synthesizer disclosed in the Non-Patent Document 1;

FIG. 22 is a block diagram showing an internal configuration of the phase comparator 104 and charge pump 105 in the frequency synthesizer;

FIG. 23 is a diagram illustrating waveforms of various portions of the phase comparator 104 and charge pump 105 when the period T of the reference signal REF is "4" and the period T of the sync signal DIV is a repetition of "6" and "2";

FIG. 24 is a block diagram showing a configuration of a phase-locked loop frequency synthesizer disclosed in the Non-Patent Document 2;

FIG. 25 is a diagram illustrating waveforms of various portions of the phase comparator 108 (EX-OR circuit) when the period T of the reference signal REF is "4" and the period T of the sync signal DIV is a repetition of "6" and "2";

FIG. 26 is a diagram illustrating detection characteristics against the phase difference when the phase comparator 104 is composed of D-type flip-flops 111 and 112;

FIG. 27 is a diagram illustrating waveforms of various portions of the EX-OR circuit when the reference signal REF and sync signal DIV with the same leading edges as those of FIG. 25 are input; and

FIG. 28 is a diagram illustrating waveforms of various portions of the phase comparator 108 (EX-OR circuit) when the period T of the reference signal REF is "8" and the period T of the sync signal DIV is a repetition of "6" and "2".

BEST MODE FOR CARRYING OUT THE INVENTION

The best mode for carrying out the invention will now be described with reference to the accompanying drawings to explain the present invention in more detail.

EMBODIMENT 1

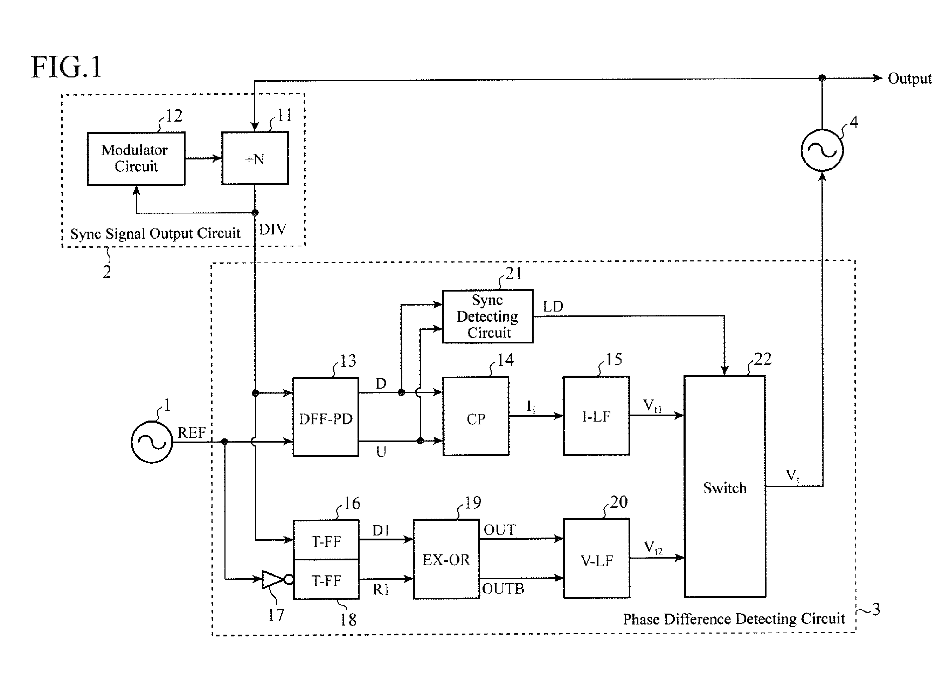

FIG. 1 is a block diagram showing a configuration of a frequency synthesizer of an embodiment 1 in accordance with the present invention.

In FIG. 1, a reference signal source 1 is a signal source that generates a reference signal REF and supplies the reference signal REF to a phase difference detecting circuit 3.

A sync signal output circuit 2 is a circuit that divides a high-frequency signal supplied from a voltage-controlled oscillator 4 and supplies the high-frequency signal after the division to the phase difference detecting circuit 3 as a sync signal DIV.

The phase difference detecting circuit 3 is a circuit that detects the phase difference between the reference signal REF generated by the reference signal source 1 and the sync signal DIV supplied from the sync signal output circuit 2, and supplies the voltage-controlled oscillator 4 with control voltage $V_t$ ($V_{t1}$ or $V_{t2}$) corresponding to the phase difference.

The voltage-controlled oscillator 4 is an oscillator that generates a high-frequency signal with the frequency corresponding to the control voltage $V_t$ ($V_{t1}$ or $V_{t2}$) supplied from the phase difference detecting circuit 3, and supplies the high-frequency signal to the sync signal output circuit 2 and outputs it to the outside.

A variable frequency divider 11 of the sync signal output circuit 2 (designated by "÷ N" in FIG. 1) executes the processing of dividing the high-frequency signal supplied from the voltage-controlled oscillator 4 in accordance with the division data supplied from the modulator circuit 12, and supplying the high-frequency signal after the division to the phase difference detecting circuit 3 as the sync signal DIV.

A modulator circuit 12, which operates in sync with the reference signal REF generated by the reference signal source 1 or with the sync signal DIV supplied from the variable frequency divider 11, executes the processing of determining the number of divisions of the variable frequency divider 11 in response to the setting signal supplied from the outside, and supplying the division data denoting the number of divisions to the variable frequency divider 11.

A D-type flip-flop 13 (designated by "DFF-PD" in FIG. 1), which is a first phase comparator of the phase difference detecting circuit 3, executes the processing of generating phase difference signals D and U from detection timing of signal edges of the reference signal REF output from the reference signal source 1 and of the sync signal DIV supplied from the variable frequency divider 11.

More specifically, the D-type flip-flop 13 executes the processing of supplying a charge pump 14 with the phase difference signals D and U corresponding to the phase difference between the reference signal REF output from the reference signal source 1 and the sync signal DIV supplied from the variable frequency divider 11.

The charge pump 14 (designated by "CP" in FIG. 1) executes the processing of supplying the charge pump current $I_i$ corresponding to phase difference signals D and U supplied from the D-type flip-flop 13 to the current-output-matching loop filter 15.

The current-output-matching loop filter 15 (designated by "I-LF" in FIG. 1) executes the processing of supplying the voltage obtained by smoothing the charge pump current $I_i$ supplied from the charge pump 14 to a switch 22 as the control voltage $V_{t1}$.

Incidentally, the charge pump 14 and current-output-matching loop filter 15 constitute a first control voltage generating circuit.

A T-type flip-flop 16 (designated by "T-FF" in FIG. 1) which is a first flip-flop executes the processing of inverting the amplitude of its output signal every time it detects a signal edge of the sync signal DIV supplied from the variable frequency divider 11.

An inverter 17 is a device for inverting the amplitude of the reference signal REF output from the reference signal source 1.

A T-type flip-flop 18 (designated by "T-FF" in FIG. 1) which is a second flip-flop executes the processing of inverting the amplitude of its output signal every time it detects a signal edge of the reference signal REF after the amplitude inversion by the inverter 17.

An EX-OR circuit 19 (designated by "EX-OR" in FIG. 1) which is a second phase comparator executes the processing of performing the exclusive OR operation for the output signal of the T-type flip-flop 16 and the output signal of the T-type flip-flop 18, and of supplying the phase difference signals OUT and OUTB indicating the operation result to a voltage-output-matching loop filter 20. Incidentally, the signals OUT and OUTB constitute a differential signal pair.

The voltage-output-matching loop filter 20 (designated by "V-LF" in FIG. 1) which is a second control voltage generating circuit executes the processing of supplying the voltage obtained by smoothing the phase difference signals OUT and OUTB supplied from the EX-OR circuit 19 to the switch 22 as the control voltage $V_{t2}$.

A sync detecting circuit 21 executes the processing of detecting the establishment of the phase sync from the phase difference signals D and U generated by the D-type flip-flop 13.

The switch 22 which is a control voltage selecting unit executes the processing of selecting, unless the sync detecting circuit 21 detects the establishment of the phase sync, the control voltage $V_{t1}$ generated by the current-output-matching loop filter 15 and of supplying the control voltage $V_{t1}$ to the voltage-controlled oscillator 4, and of selecting, if the sync detecting circuit 21 detects the establishment of the phase sync, the control voltage $V_{t2}$ generated by the voltage-output-matching loop filter 20 and of supplying the control voltage $V_{t2}$ to the voltage-controlled oscillator 4.

Next, the operation will be described.

The reference signal source 1 generates the reference signal REF and supplies the reference signal REF to the D-type flip-flop 13 and inverter 17 in the phase difference detecting circuit 3. It is assumed here that the reference signal REF has a duty factor of 50%.

The variable frequency divider 11 in the sync signal output circuit 2 divides the high-frequency signal output from the voltage-controlled oscillator 4 which will be described later in accordance with the division data fed from the modulator circuit 12, and supplies the high-frequency signal after the division to the D-type flip-flop 13 and T-type flip-flop 16 in the phase difference detecting circuit 3 as the sync signal DIV.

Incidentally, the modulator circuit 12 in the sync signal output circuit 2, which operates in sync with the reference signal REF generated by the reference signal source 1 or the sync signal DIV supplied from the variable frequency divider 11, determines the number of divisions of the variable frequency divider 11 in response to the setting signal fed from the outside, and supplies the division data designating the number of divisions to the variable frequency divider 11.

The D-type flip-flop 13 in the phase difference detecting circuit 3, receiving the reference signal REF from the reference signal source 1 and the sync signal DIV from the variable frequency divider 11, supplies the phase difference signals D and U corresponding to the phase difference between the reference signal REF and the sync signal DIV to the charge pump 14.

Receiving the phase difference signals D and U from the D-type flip-flop 13, the charge pump 14 supplies the charge pump current $I_i$ corresponding to the phase difference signals D and U to the current-output-matching loop filter 15.

For example, when the D-type flip-flop 13 and charge pump 14 have a configuration as shown in FIG. 22 (in FIG. 22, the phase comparator 104 corresponds to the D-type flip-flop 13 and the charge pump 105 corresponds to the charge pump 14), the D-type flip-flop 13 and charge pump 14 operate as follows.

The D-type flip-flop 111 receives the reference signal REF output from the reference signal source 1 and the reset signal RST, and supplies the leading edge detection signal D of the reference signal REF to the AND circuit 113 and the switch 116 in the charge pump 14.

On the other hand, the D-type flip-flop 112 receives the sync signal DIV supplied from the variable frequency divider 11 and the reset signal RST, and supplies the leading edge detection signal U of the sync signal DIV to the AND circuit 113 and the switch 117 in the charge pump 14.

The AND circuit 113 receives the leading edge detection signal D output from the D-type flip-flop 111 and the leading edge detection signal U output from the D-type flip-flop 112, performs the AND operation for the leading edge detection signal D and leading edge detection signal U, and supplies the operation result to the D-type flip-flops 111 and 112 as the reset signal RST.

The constant-current source 115, which is connected to the power supply circuit 114, generates the prescribed current $I_i$.

The constant-current source 118, which is connected to the ground terminal 119, generates the prescribed current $I_i$, and supplies the current $I_i$ toward the ground terminal 119.

The switch 116 becomes ON state when it receives the leading edge detection signal D from the D-type flip-flop 111.

The switch 117 becomes ON state when it receives the leading edge detection signal U from the D-type flip-flop 112.

Receiving the charge pump current $I_i$ from the charge pump 14, the current-output-matching loop filter 15 supplies the voltage obtained by smoothing the charge pump current $I_i$ to the switch 22 as the control voltage $V_{t1}$.

Receiving the sync signal DIV from the variable frequency divider 11, the T-type flip-flop 16 detects a signal edge of the sync signal DIV, inverts the amplitude of its output signal every time it detects the signal edge of the sync signal DIV (inverts the state of the output signal from logic high to logic low or from logic low to logic high), and supplies the signal D1 after the amplitude inversion to the EX-OR circuit 19.

Receiving the reference signal REF from the reference signal source 1, the inverter 17 inverts the amplitude of the reference signal REF, and supplies the reference signal REF after the amplitude inversion to the T-type flip-flop 18.

The T-type flip-flop 18 detects a signal edge of the reference signal REF after the amplitude inversion by the inverter 17, inverts the amplitude of its output signal every time it detects the signal edge of the reference signal REF (inverts the state of the output signal from logic high to logic low or from logic low to logic high), and supplies the signal R1 after the amplitude inversion to the EX-OR circuit 19.

The EX-OR circuit 19 performs the exclusive OR operation for the output signal D1 of the T-type flip-flop 16 and the output signal R1 of the T-type flip-flop 18, and supplies the phase difference signals OUT and OUTB indicating the operation result to the voltage-output-matching loop filter 20. The signals OUT and OUTB constitute a differential signal pair.

Receiving the phase difference signals OUT and OUTB from the EX-OR circuit 19, the voltage-output-matching loop filter 20 supplies the voltage obtained by smoothing the phase difference signals OUT and OUTB to the switch 22 as the control voltage $V_{t2}$.

Receiving the phase difference signals D and U from the D-type flip-flop 13, the sync detecting circuit 21 detects the establishment of the phase sync from the phase difference signals D and U.

When the establishment of the phase sync is not detected (when the time difference between the leading edges between the reference signal REF and sync signal DIV is greater than a prescribed threshold), the sync detecting circuit 21 supplies the switch 22 with the sync signal LD with logic low indicating that the phase sync has not yet been established. When the establishment of the phase sync is detected (when the time difference between the leading edges of the reference signal REF and sync signal DIV is less than the prescribed threshold), the sync detecting circuit 21 supplies the switch 22 with the sync signal LD with logic high indicating that the phase sync has been established.

Receiving the sync signal LD with logic low indicating that the phase sync has not yet been established from the sync detecting circuit 21, the switch 22 selects the control voltage $V_{t1}$ generated by the current-output-matching loop filter 15, and supplies the control voltage $V_{t1}$ to the voltage-controlled oscillator 4.

Receiving the sync signal LD with logic high indicating that the phase sync has been established from the sync detecting circuit 21, the switch 22 selects the control voltage $V_{t2}$ generated by the voltage-output-matching loop filter 20, and supplies the control voltage $V_{t2}$ to the voltage-controlled oscillator 4.

Receiving the control voltage $V_t$ ($V_{t1}$ or $V_{t2}$) from the phase difference detecting circuit 3, the voltage-controlled oscillator 4 generates the high-frequency signal with the frequency corresponding to the control voltage $V_t$ ($V_{t1}$ or $V_{t2}$), outputs the high-frequency signal to the sync signal output circuit 2 and to the outside.

As described above, the frequency synthesizer of the present embodiment 1 selects the control voltage $V_{t1}$ generated from the phase difference signals D and U which are the output of the D-type flip-flop 13 or the control voltage $V_{t2}$ generated from the phase difference signals OUT and OUTB which are the output of the EX-OR circuit 19 in accordance with the state of the phase sync, and generates the high-frequency signal.

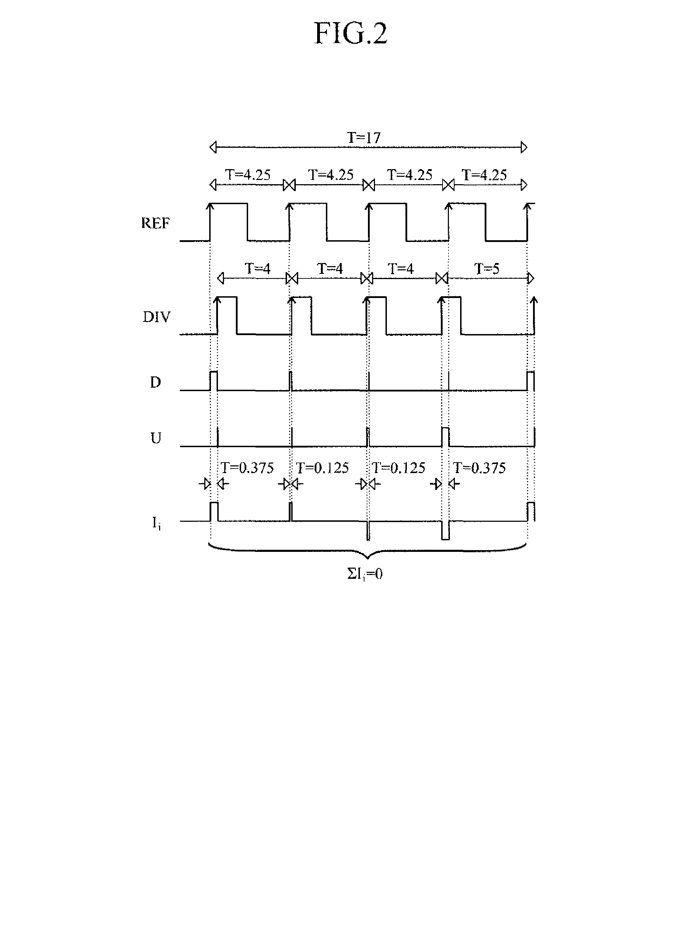

FIG. 2 is a diagram illustrating waveforms of various portions of the D-type flip-flop 13 and charge pump 14 when the period T of the reference signal REF is "4.25", the period T of the sync signal DIV is a repetition of "4", "4", "4" and "5".

Incidentally, the reference signal REF has a duty factor of 50%, the sync signal DIV with a period T of "4" has a duty factor of 25%, and the sync signal DIV with a period T of "5" has a duty factor of 20%.

Since the D-type flip-flop 13 detects the time difference between the leading edges of the reference signal REF and sync signal DIV as the phase difference, it is not affected by the duty factor of the sync signal DIV that varies in accordance with the period T.

Once the phase sync has been established, the integrated result of the charge pump current $I_i$ over one period of the division number pattern that changes with respect to time becomes zero ideally, and the control voltage $V_{t1}$ is maintained at the prescribed voltage.

As for the operation described above, it is the same as the operation of the phase comparator of the conventional frequency synthesizer disclosed in the Non-Patent Document 1 or Non-Patent Document 2.

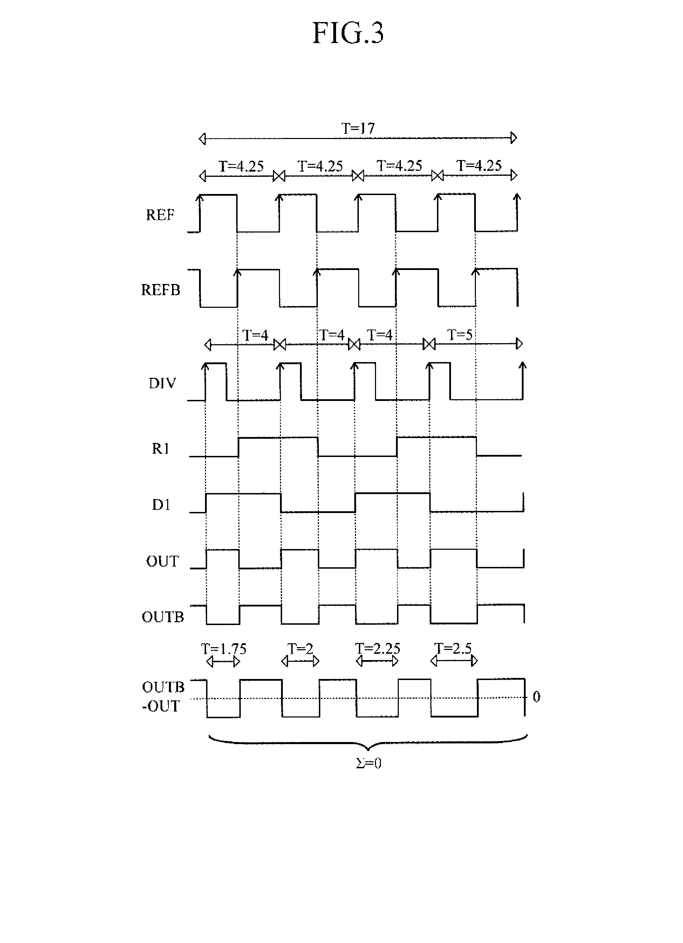

FIG. 3 is a diagram illustrating waveforms of various portions of the T-type flip-flops 16 and 18 and EX-OR circuit 19 when the period T of the reference signal REF is "4.25", the period T of the sync signal DIV is a repetition of "4", "4", "4" and "5".

Incidentally, the reference signal REF has a duty factor of 50%, the sync signal DIV with the period T of "4" has a duty factor of 25%, and the sync signal DIV with the period T of "5" has a duty factor of 20%.

Using the T-type flip-flops 16 and 18 can generate the signals (R1, D1) with a state of logic high or logic low over one period of the reference signal REF and sync signal DIV.

The EX-OR circuit 19 detects the phase difference in terms of the time difference between the states of the signals R1 and D1 which indicate the period, thereby being able to nullify the effect of the duty factor of the sync signal DIV that varies in response to the period.

Once the phase sync has been established, the integrated result of the difference signal (OUTB - OUT) over one period of the time varying pattern becomes zero ideally, and the control voltage $V_{t2}$ is maintained at a prescribed voltage.

As is clear from the foregoing, according to the present embodiment 1, the phase difference detecting circuit 3 comprises the D-type flip-flop 13 for generating the phase difference signals D and U from the detection timing of signal edges of the reference signal REF and sync signal DIV; the current-output-matching loop filter 15 for generating the control voltage $V_{t1}$ corresponding to the phase difference signals D and U generated by the D-type flip-flop 13; the T-type flip-flop 16 for inverting the amplitude of its output signal every time it detects a signal edge of the sync signal DIV; the inverter 17 for inverting the amplitude of the reference signal REF; the T-type flip-flop 18 for inverting the amplitude of its output signal every time it detects a signal edge of the reference signal after the amplitude inversion by the inverter 17; the EX-OR circuit 19 for performing the exclusive OR operation for the output signals of the T-type flip-flops 16 and 18 and for outputting the phase difference signals OUT and OUTB indicating the operation result; the voltage-output-matching loop filter 20 for generating the control voltage $V_{t2}$ corresponding to the phase difference signals OUT and OUTB output from the EX-OR circuit 19; the sync detecting circuit 21 for detecting the establishment of the phase sync from the phase difference signals D and U generated by the D-type flip-flop 13; and the switch 22 for supplying, unless the sync detecting circuit 21 detects the establishment of the phase sync, the control voltage $V_{t1}$ generated bycurrent-output-matchingloop filter 15 to the voltage-controlled oscillator 4, and for supplying, when the sync detecting circuit 21 detects the establishment of the phase sync, the control voltage $V_{t2}$ generated by the voltage-output-matching loop filter 20 to the voltage-controlled oscillator 4. Accordingly, it offers an advantage of being able to achieve the low spurious characteristics.

More specifically, according to the present embodiment 1, it can solve the problems of the conventional examples which use the D-type flip-flop or EX-OR circuit singly as the phase comparator of the frequency synthesizer.
First, after the phase sync establishment, using the output of the EX-OR circuit 19 without using the output of the D-type flip-flop 13 can prevent the spurious emission due to variations between the circuits in the D-type flip-flop 13.
Second, using as the input to the EX-OR circuit 19 the signals (R1 and D1) indicating the periods of the reference signal REF and sync signal DIV can prevent the spurious emission due to fluctuations of the duty factor of the sync signal DIV.
Third, using the output of the D-type flip-flop 13 to establish the phase sync without using the output of the EX-OR circuit 19 can prevent it from being controlled by a false frequency.

In addition, since the temporal relationships between the reference signal REF and sync signal DIV after the phase sync establishment shown in FIG. 2 and FIG. 3 are the same, discontinuity of the control voltage $V_t$ does not exist ideally when the switch 22 switches the control voltage $V_t$ from $V_{t1}$ to $V_{t2}$ after the establishment of the phase sync. Thus, the output frequency has no fluctuations involved in the switching of the switch 22.

Incidentally, although the present embodiment 1 shows an example in which the reference signal REF has a duty factor of 50%, if its duty factor is not 50%, discontinuity of the control voltage $V_t$ can occur when the control voltage $V_t$ is switched from $V_{t1}$ to $V_{t2}$ by the switch 22 after the establishment of the phase sync (the voltage difference between $V_{t1}$ and $V_{t2}$ is smaller as the duty factor is closer to 50%).
To convert the duty factor of the reference signal REF to 50%, a publicly known technique can be employed such as dividing the frequency by two, that is, doubling the frequency, or using a narrow-band filter.

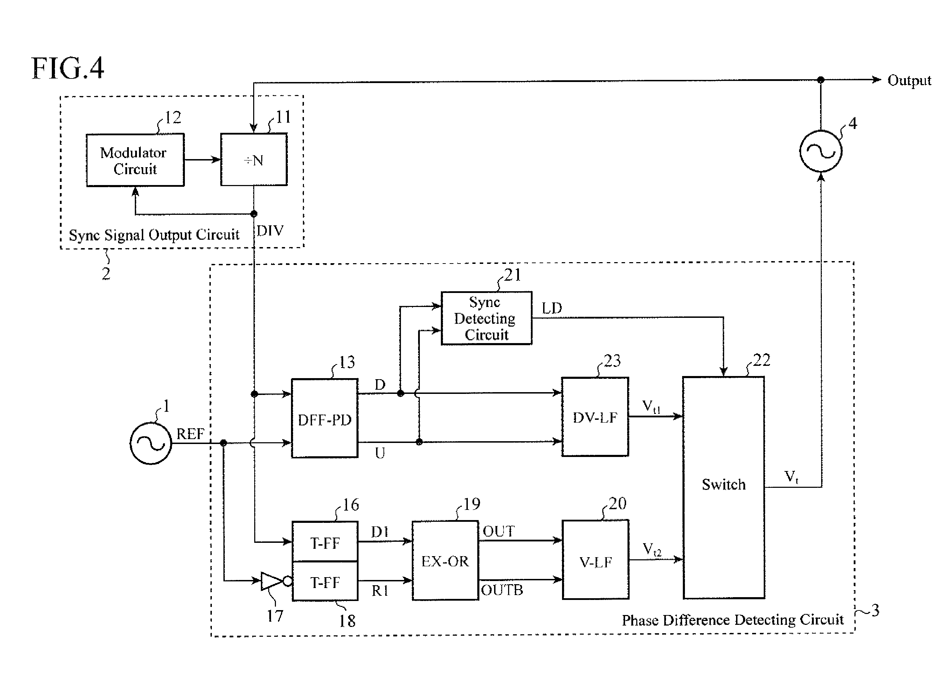

Although the present embodiment 1 shows an example that comprises the charge pump 14 and the current-output-matching loop filter 15 after the D-type flip-flop 13 to generate the control voltage $V_{t1}$, a configuration which comprises a voltage-output-matching loop filter 23 (designated by "DV-LF" in FIG. 4) for the D-type flip-flop instead of the charge pump 14 and the current-output-matching loop filter 15 as shown in FIG. 4 and which generates the control voltage $V_{t1}$ can offer the same advantage.

In addition, although the present embodiment 1 supposes operationby detecting the leading edges of the individual signals, operation by detecting the falling edges of the individual signals can also achieve the same advantages.

EMBODIMENT 2

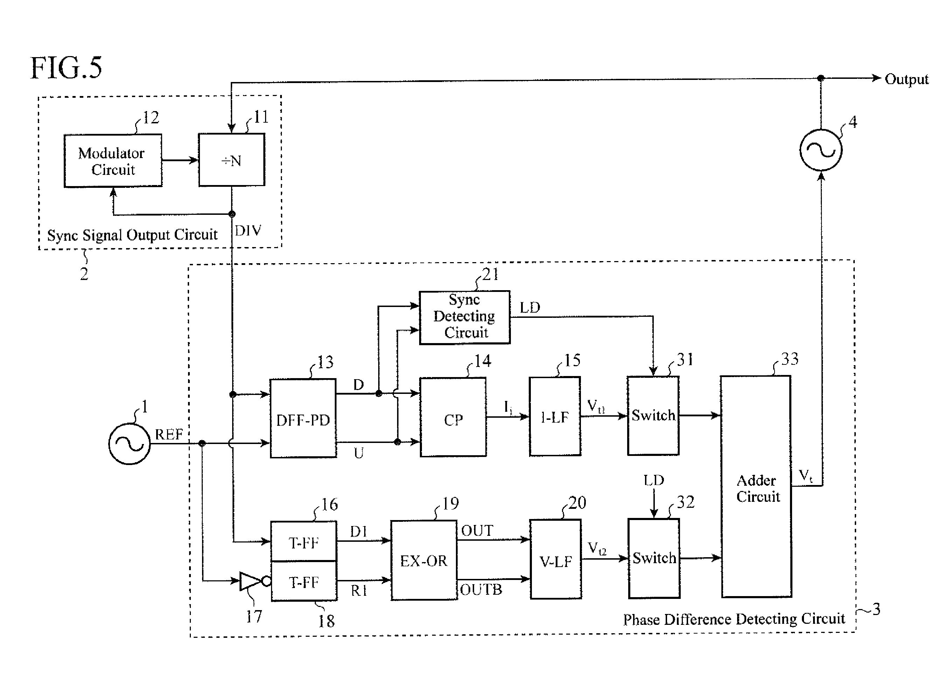

FIG. 5 is a block diagram showing a configuration of a frequency synthesizer of an embodiment 2 in accordance with the present invention. In FIG. 5, since the same reference numerals as those of FIG. 1 designate the same or like components, their description will be omitted.
A switch 31, which is placed at the output side of the current-output-matching loop filter 15, is a switch which closes when the sync detecting circuit 21 does not detect the establishment of the phase sync, and opens when the sync detecting circuit 21 detects the establishment of the phase sync.
A switch 32, which is placed at the output side of the voltage-output-matching loop filter 20, is a switch which closes when the sync detecting circuit 21 detects the establishment of the phase sync, and opens when the sync detecting circuit 21 does not detect the establishment of the phase sync.

An adder circuit 33 is a circuit that adds the control voltage $V_{t1}$ which is the output of the first signal path from the D-type flip-flop 13 to the switch 31 (the control voltage which is zero when the switch 31 is open) and the control voltage $V_{t2}$ which is the output of the second signal path from the EX-OR circuit 19 to the switch 32 (the control voltage which is zero when the switch 32 is open), and supplies the control voltage $V_t$ after the addition to the voltage-controlled oscillator 4.
Incidentally, the switches 31 and 32 and the adder circuit 33 constitute a control voltage selecting unit.

Although the embodiment 1 shows the phase difference detecting circuit 3 comprising the single switch 22, the phase difference detecting circuit 3 can also comprise the two switches 31 and 32, offering the same advantages of the embodiment 1.
Since the configuration is the same as the embodiment 1 excerpt for the switches 31 and 32 and the adder circuit 33, only the operation of the switches 31 and 32 and the adder circuit 33 will be described.

When receiving the sync signal LD with logic low indicating that the phase sync has not yet been established from the sync detecting circuit 21, the switch 31 is closed to supply the control voltage $V_{t1}$ generated by the current-output-matching loop filter 15 to the adder circuit 33.
On the other hand, when receiving the sync signal LD with logic high indicating that the phase sync has been established from the sync detecting circuit 21, the switch 31 is opened to supply the control voltage $V_{t1}$ of zero (no-signal) to the adder circuit 33.

Receiving the sync signal LD with logic high indicating that the phase sync has been established from the sync detecting circuit 21, the switch 32 is closed to supply the control voltage $V_{t2}$ generated by the voltage-output-matching loop filter 20 to the adder circuit 33.

On the other hand, receiving the sync signal LD with logic low indicating that the phase sync has not yet been established from the sync detecting circuit 21, the switch 32 is opened to supply the control voltage $V_{t2}$ of zero (no-signal) to the adder circuit 33.

The adder circuit 33 adds the control voltage $V_{t1}$ supplied from the switch 31 and the control voltage $V_{t2}$ supplied from the switch 32, and supplies the control voltage $V_t$ after the addition which is given by the following Expression (1) to the voltage-controlled oscillator 4.

$$V_t = \alpha \cdot V_{t1} + \beta \cdot V_{t2} \qquad (1)$$

where $\alpha$ and $\beta$ are any given coefficients. When the duty factor of the reference signal REF is not 50%, setting $\alpha$ and $\beta$ at appropriate values enables compensating for the voltage difference between the control voltage $V_{t1}$ and the control voltage $V_{t2}$.

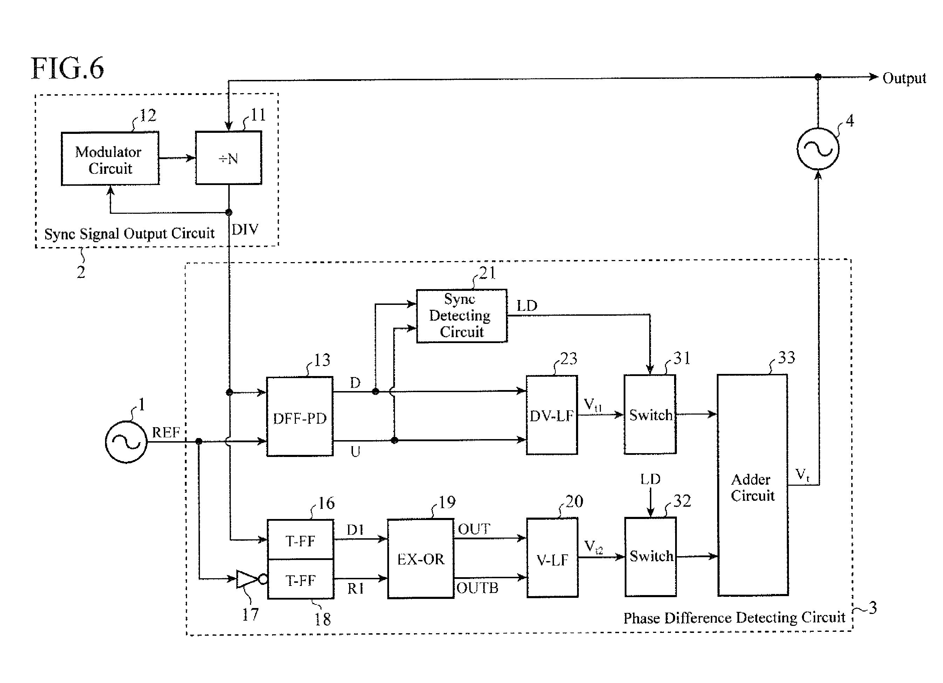

Although the present embodiment 2 shows an example that incorporates the charge pump 14 and the current-output-matching loop filter 15 after the D-type flip-flop 13 for generating the control voltage $V_{t1}$, a configuration as shown in FIG. 6, which comprises the voltage-output-matching loop filter 23 for the D-type flip-flop used instead of the charge pump 14 and the current-output-matching loop filter 15 to generate the control voltage $V_{t1}$, can also achieve the same advantages.

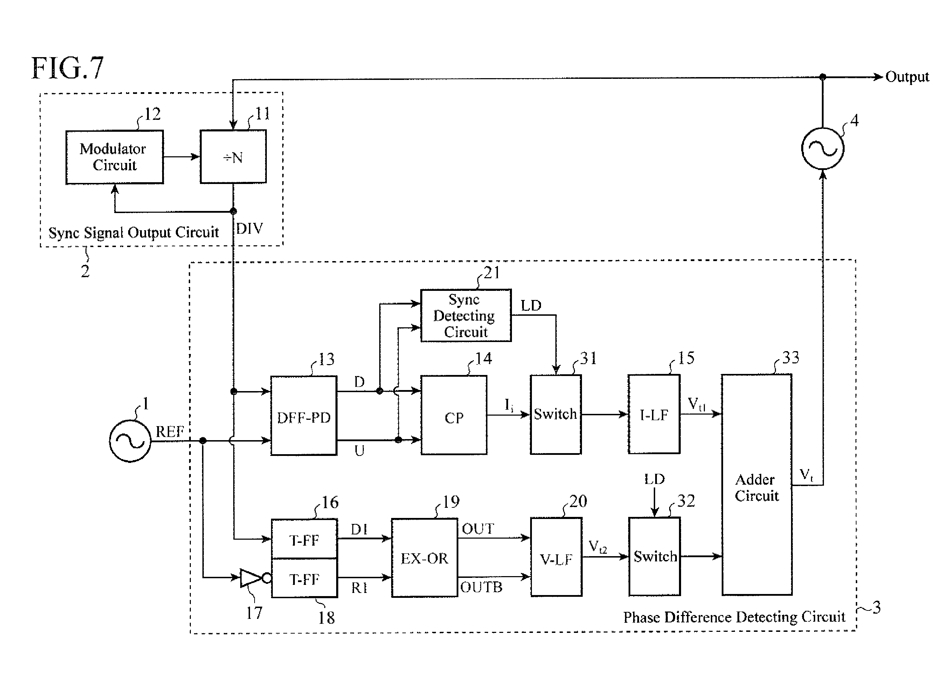

Although the present embodiment 2 shows an example which has the switch 31 placed at the output side of the current-output-matching loop filter 15 on the first signal path from the D-type flip-flop 13 to the output side of the current-output-matching loop filter 15, a configuration as shown in FIG. 7 is also possible which has the switch 31 placed between the charge pump 14 and the current-output-matching loop filter 15.

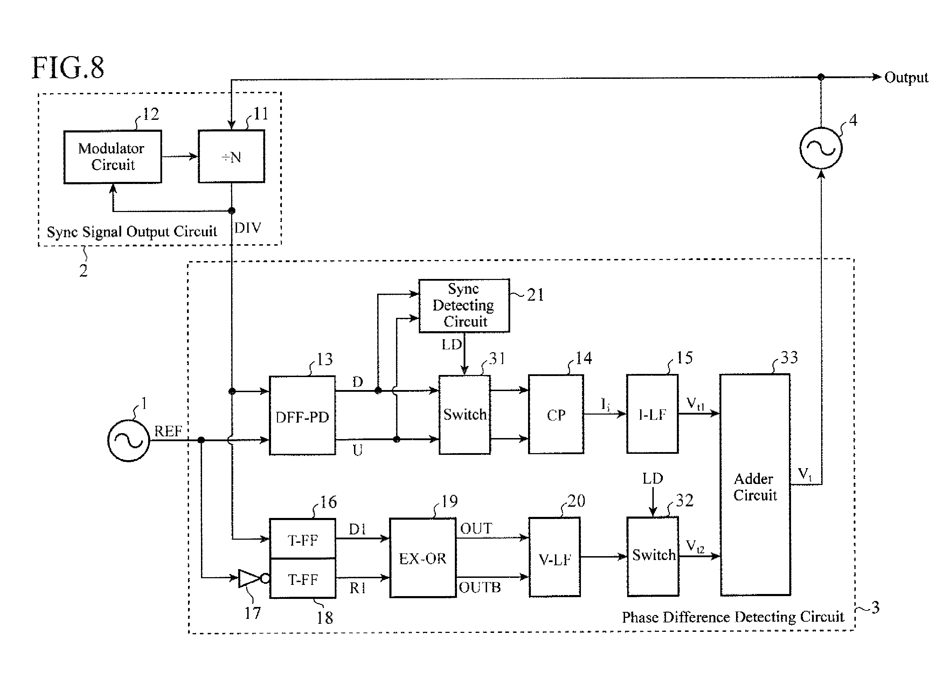

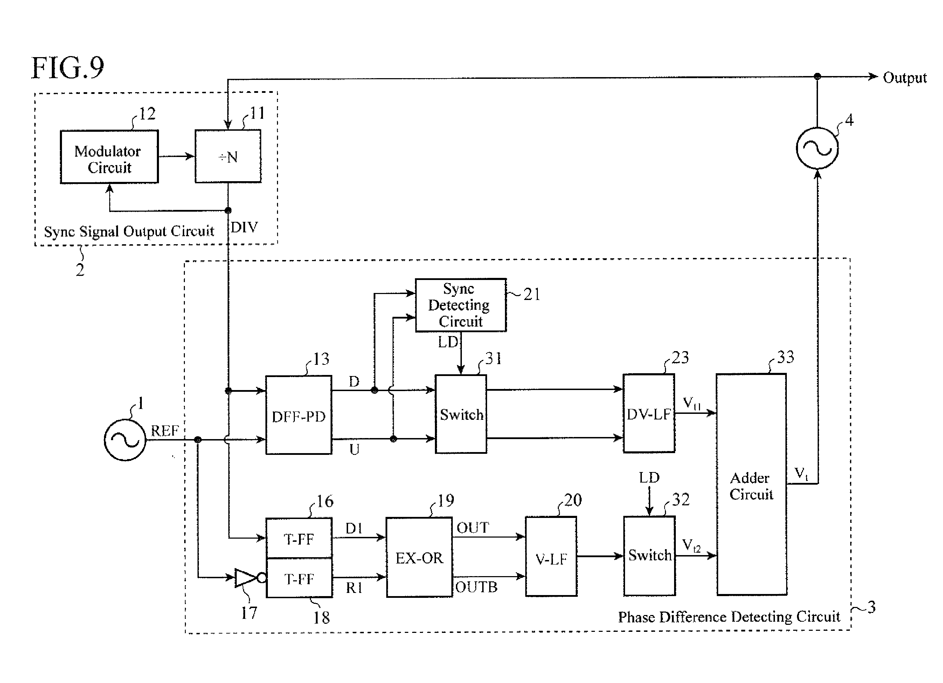

In addition, as shown in FIG. 8, the switch 31 can be placed between the D-type flip-flop 13 and the charge pump 14. Furthermore, as shown in FIG. 9, the switch 31 can be placed between the D-type flip-flop 13 and the voltage-output-matching loop filter 23 for the D-type flip-flop.

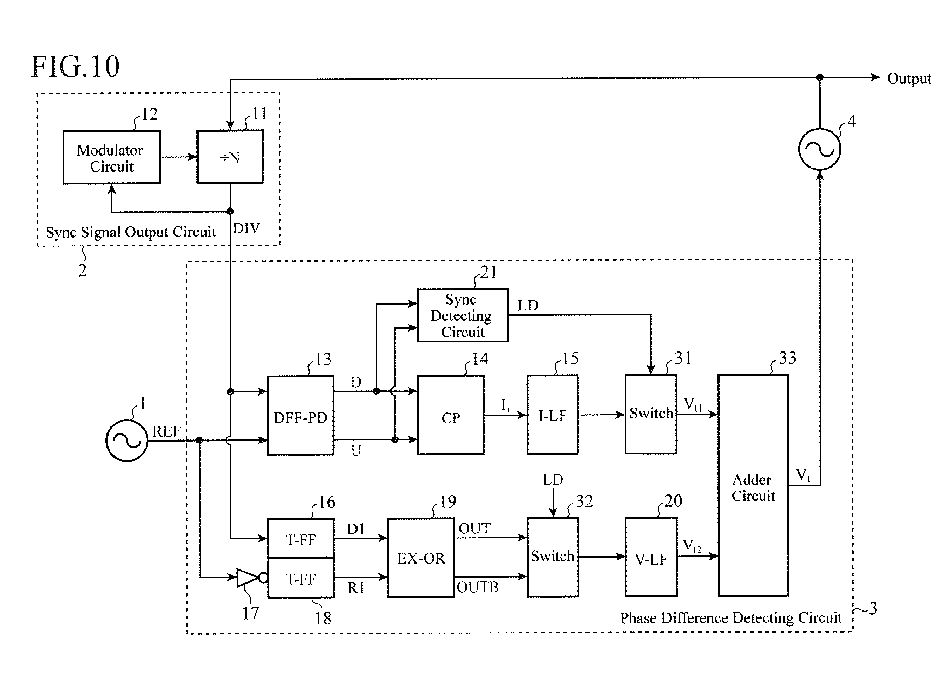

Although the present embodiment 2 shows an example which has the switch 32 placed at the output side of the voltage-output-matching loop filter 20 on the second signal path from the EX-OR circuit 19 to the output side of the voltage-output-matching loop filter 20, a configuration as shown in FIG. 10 is also possible which has the switch 32 placed between the EX-OR circuit 19 and the voltage-output-matching loop filter 20.

EMBODIMENT 3

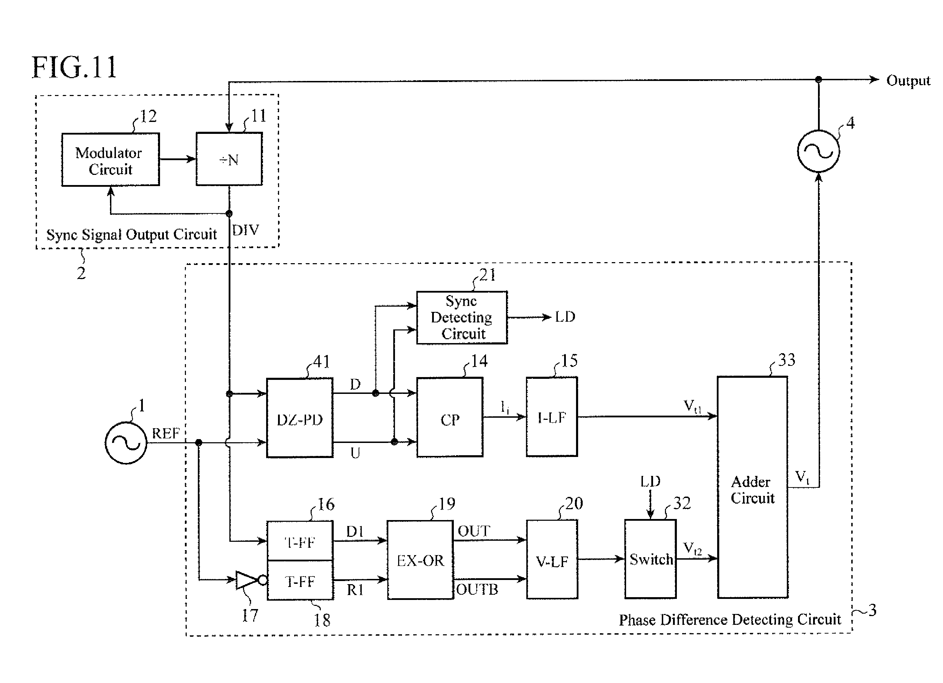

FIG. 11 is a block diagram showing a configuration of a frequency synthesizer of an embodiment 3 in accordance with the present invention. In FIG. 11, since the same reference numerals as those of FIG. 5 designate the same or like components, their description will be omitted.

A dead-zone phase comparator 41 (designated by "DZ-PD" in FIG. 11), which is a first phase comparator, executes in the same manner as the D-type flip-flop 13 the processing of supplying the charge pump 14 with the phase difference signals D and U corresponding to the phase difference between the reference signal REF output from the reference signal source 1 and the sync signal DIV supplied from the variable frequency divider 11. However, it differs from the D-type flip-flop 13 in that it has a characteristic of generating the phase difference signal of zero when the time difference in the detection timing between signal edges of the reference signal REF and sync signal DIV is less than a prescribed value.

The present embodiment 3 differs from the embodiment 2 in that it comprises the dead-zone phase comparator 41 instead of the D-type flip-flop 13 and that it does not have the switch 31.

The operation of the dead-zone phase comparator 41 will be described below.

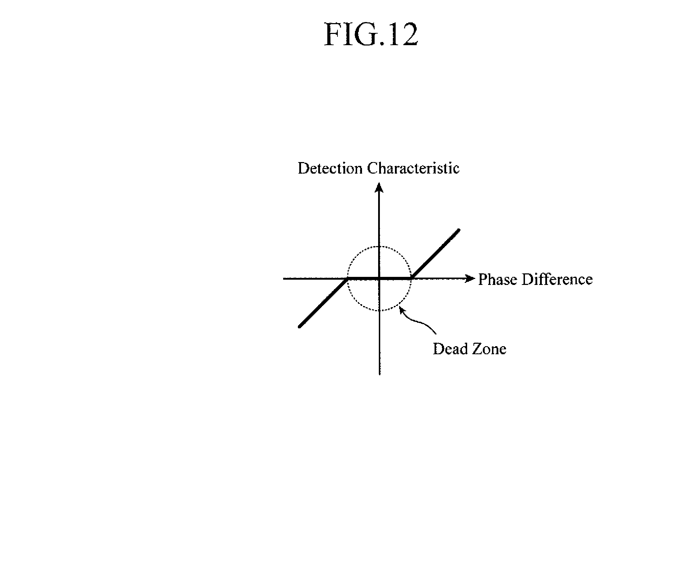

FIG. 12 is a diagram illustrating the detection characteristics against the phase difference when the dead-zone phase comparator 41 is used.

Although the dead-zone phase comparator 41 supplies the charge pump 14 with phase difference signals D and U corresponding to the phase difference between the reference signal REF output from the reference signal source 1 and the sync signal DIV supplied from the variable frequency divider 11 in the same manner as the D-type flip-flop 13, it has as shown in FIG. 12 a characteristic of generating the phase difference signal of zero if the time difference in detection timing between the signal edges of the reference signal REF and sync signal DIV is less than the prescribed value.

More specifically, as shown in FIG. 12, the dead-zone phase comparator 41 has the detection output of zero in the neighborhood of the point where the phase difference is zero.

The conventional frequency synthesizer disclosed in the Non-Patent Document 2 has spurious emission due to the detection characteristics as shown in FIG. 12.

However, because the frequency synthesizer of the present embodiment 3 does not use the control voltage $V_{t1}$ based on the phase difference signals D and U which are the output of the dead-zone phase comparator 41 after the establishment of the phase sync, it does not cause the spurious emission.

When using the dead-zone phase comparator 41, since the detection output after the phase sync establishment is zero, the control voltage $V_{t1}$ is zero as well.

Accordingly, it is not necessary for the phase difference detecting circuit 3 to have the switch 31, thereby being able to simplify the circuit.

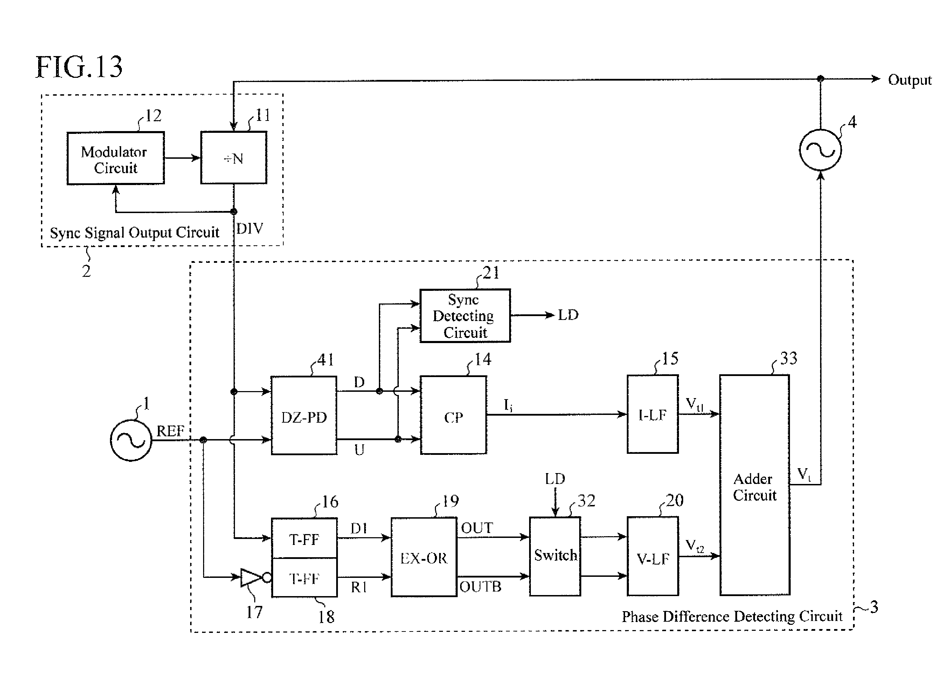

Although the present embodiment 3 shows an example which comprises the switch 32 at the output side of the voltage-output-matching loop filter 20 on the second signal path from the EX-OR circuit 19 to the output side of the voltage-output-matching loop filter 20, the switch 32 can also be placed between the EX-OR circuit 19 and the voltage-output-matching loop filter 20 as shown in FIG. 13.

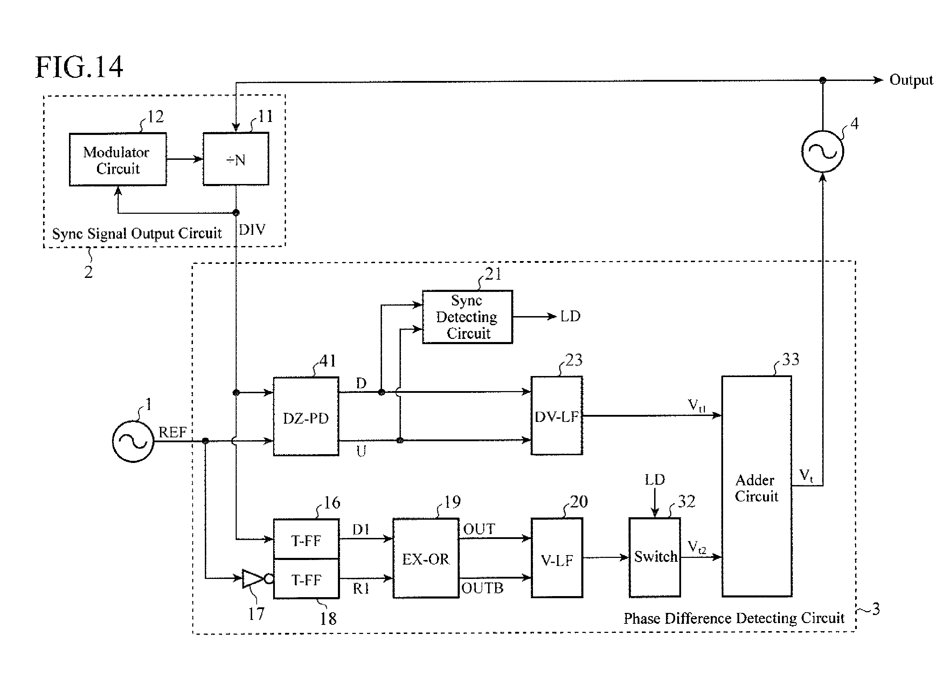

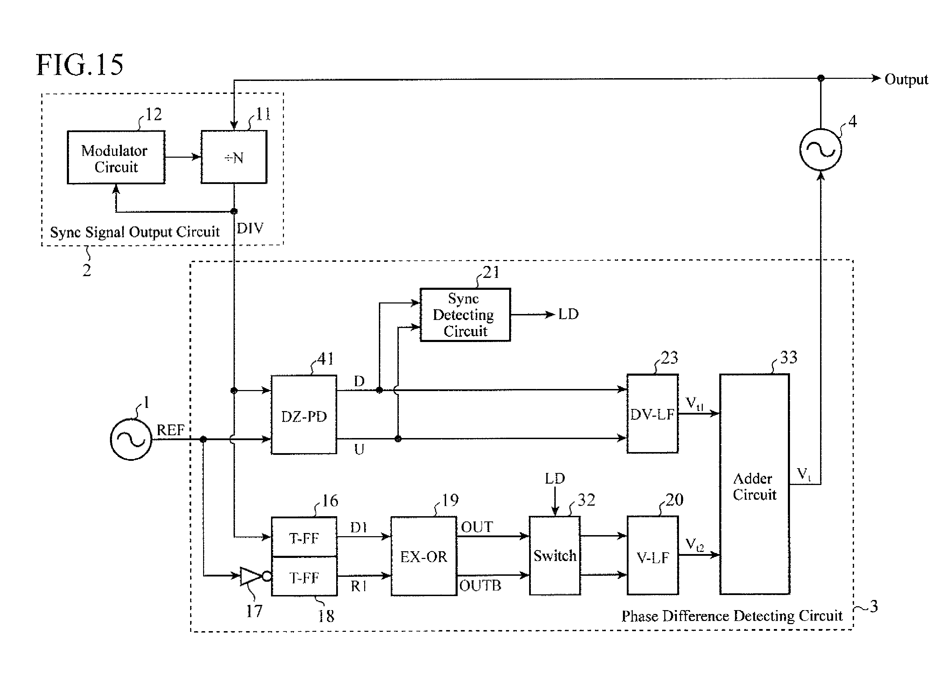

In addition, although the present embodiment 3 shows an example in which the phase difference detecting circuit 3 comprises the charge pump 14 and current-output-matching loop filter 15, the phase difference detecting circuit 3 can comprise in place of them the voltage-output-matching loop filter 23 for the D-type flip-flop as shown in FIG. 14 and FIG. 15.


EMBODIMENT 4

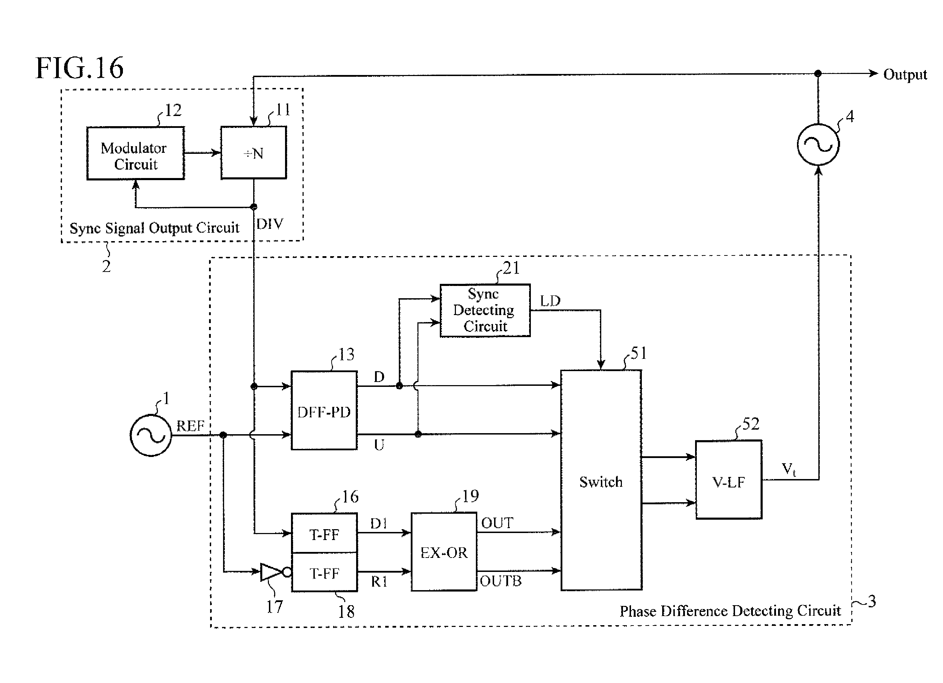

FIG. 16 is a block diagram showing a configuration of a frequency synthesizer of an embodiment 4 in accordance with the present invention. In FIG. 16, since the same reference numerals as those of FIG. 1 designate the same or like components, their description will be omitted.

A switch 51, which is a control voltage selecting unit, executes the processing of selecting, unless the sync detecting circuit 21 detects the establishment of the phase sync, the phase difference signals D and U generated by the D-type flip-flop 13 and supplying the phase difference signals D and U to the voltage-output-matching loop filter 52, and of selecting, if the sync detecting circuit 21 detects the establishment of the phase sync, the phase difference signals OUT and OUTB output from the EX-OR circuit 19 and supplying the phase difference signals OUT and OUTB to the voltage-output-matching loop filter 52.

The voltage-output-matching loop filter 52 (designated by "V-LF" in FIG. 16), which is a control voltage generating circuit, executes the processing of supplying the voltage obtained by smoothing the phase difference signals D and U or the phase difference signals OUT and OUTB supplied from the switch 51 to the voltage-controlled oscillator 4 as the control voltage $V_t$.

Next, the operation will be described.

Since the operation other than the switch 51 and voltage-output-matching loop filter 52 is the same as that of the embodiment 1, its description will be omitted here.

Receiving the sync signal LD with logic low indicating that the phase sync has not yet been established from the sync detecting circuit 21, the switch 51 selects the phase difference signals D and U generated by the D-type flip-flop 13 and supplies the phase difference signals D and U to the voltage-output-matching loop filter 52.

On the other hand, receiving the sync signal LD with logic high indicating that the phase sync has been established from the sync detecting circuit 21, the switch 51 selects the phase difference signals OUT and OUTB fed from the EX-OR circuit 19 and supplies the phase difference signals OUT and OUTB to the voltage-output-matching loop filter 52.

Receiving the phase difference signals D and U or the phase difference signals OUT and OUTB from the switch 51, the voltage-output-matching loop filter 52 supplies the voltage obtained by smoothing the phase difference signals D and U or phase difference signals OUT and OUTB to the voltage-controlled oscillator 4 as the control voltage $V_t$.

According to the present embodiment 4, it can not only implement low spurious characteristics as the foregoing embodiments 1-3, but also reduce the number of the loop filters to one, thereby offering an advantage of being able to simplify the circuit.

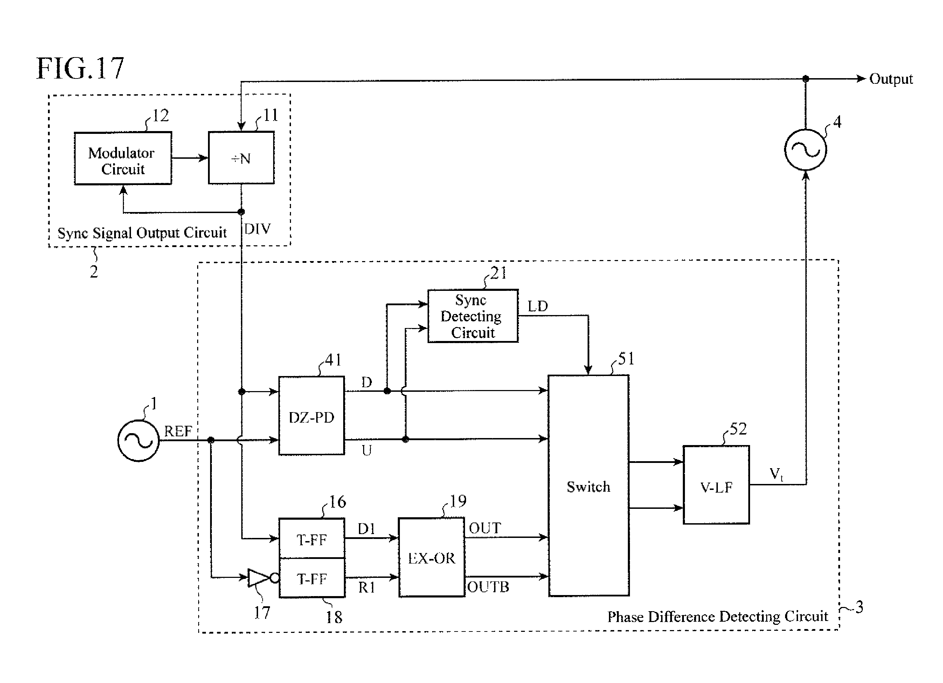

Although the present embodiment 4 shows an example in which the phase difference detecting circuit 3 comprises the D-type flip-flop 13, the phase difference detecting circuit 3 can comprise the dead-zone phase comparator 41 as shown in FIG. 17.


EMBODIMENT 5

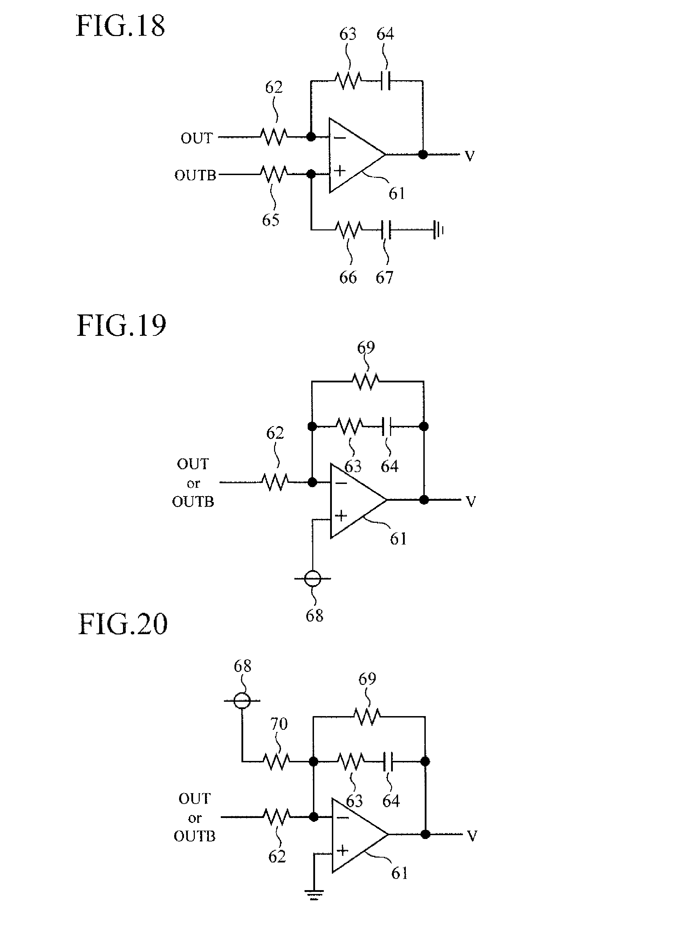

Although the foregoing embodiments 1 - 4 show examples in which the voltage-output-matching loop filter 20 outputs the voltage obtained by smoothing the phase difference signals OUT and OUTB fed from the EX-OR circuit 19 as the control voltage $V_{t2}$, a configuration as shown in FIG. 18 is conceivable as a concrete arrangement of the voltage-output-matching loop filter 20, for example.

In the example of FIG. 18, the voltage-output-matching loop filter 20 comprises an operational amplifier 61, resistors 62, 63, 65 and 66 and capacitors 64 and 67.

In the voltage-output-matching loop filter 20, the operational amplifier 61 has its inverting input terminal supplied with the phase dif f erence signal OUT and its noninverting input terminal supplied with the phase difference signal OUTB which is paired with the phase difference signal OUT to form the differential signal. Thus the operational amplifier 61 outputs from its output terminal the smoothed difference signal (OUTB - OUT) as the control voltage $V_{t2}$.

In addition, as a concrete arrangement of the voltage-output-matching loop filter 20, a configuration as shown in FIG. 19 is conceivable.

In the example of FIG. 19, the voltage-output-matching loop filter 20 comprises an operational amplifier 61, resistors 62, 63 and 69, a capacitor 64 and a DC power supply 68 for offset.

In the example of FIG. 19, the operational amplifier 61 has its inverting input terminal supplied with one of the phase difference signals OUT and OUTB, which are the differential signal pair, and thus produces from its output terminal the smoothed voltage as the control voltage $V_{t2}$.

When the ideal operation is carried out , the DC offset voltage of the phase difference signals OUT and OUTB output from the EX-OR circuit 19 is half the power supply voltage Vcc of the EX-OR circuit 19.

Thus, the voltage-output-matching loop filter 20 of FIG. 19 employs the DC power supply 68 for offset to compensate for the DC offset contained in the phase difference signal OUT or phase difference signal OUTB.

Furthermore, as a concrete arrangement of the voltage-output-matching loop filter 20, a configuration as shown in FIG. 20 is also conceivable.

In the example of FIG. 20, the voltage-output-matching loop filter 20 comprises an operational amplifier 61, resistors 62, 63, 69 and 70, a capacitor 64 and a DC power supply 68 for offset.

In the example of FIG. 20, the operational amplifier 61 has its inverting input terminal supplied with one of the phase difference signals OUT and OUTB which are the differential signal pair, and outputs from its output terminal the smoothed voltage as the control voltage $V_{t2}$.

The voltage-output-matching loop filter 20 of FIG. 20 compensates for the DC offset contained in the phase difference signal OUT or OUTB using the DC power supply 68 for offset in the same manner as the voltage-output-matching loop filter 20 in FIG. 19.

Incidentally, it is to be understood that a free combination of the individual embodiments, variations of any components of the individual embodiments or removal of any components of the individual embodiments are possible within the scope of the present invention.

INDUSTRIAL APPLICABILITY

A frequency synthesizer in accordance with the present invention is applicable to a radio communication apparatus, for example, and is particularly suitable for a radio communication apparatus requiring low spurious characteristics.

DESCRIPTION OF REFERENCE NUMERALS

1 reference signal source; 2 sync signal output circuit; 3 phase difference detecting circuit; 4 voltage-controlled oscillator; 11 variable frequency divider; 12 modulator circuit; 13 D-type flip-flop (first phase comparator) ; 14 charge pump (first control voltage generating circuit); 15 current-output-matching loop filter (first control voltage generating circuit) ; 16 T-type flip-flop (first flip-flop) ; 17 inverter; 18 T-type flip-flop (second flip-flop); 19 EX-OR circuit (second phase comparator); 20 voltage-output-matching loop filter (second control voltage generating circuit) ; 21 sync detecting circuit; 22 switch (control voltage selecting unit); 23 voltage-output-matching loop filter for D-type flip-flop; 31, 32 switch (control voltage selecting unit) ; 33 adder circuit (control voltage selecting unit) ; 41 dead-zone phase comparator (first phase comparator) ; 51 switch (control voltage selecting unit) ; 52 voltage-output-matching loop filter (control voltage generating circuit); 61 operational amplifier; 62, 63, 65, 66, 69, 70 resistors ; 64, 67 capacitor; 68 DC power supply for offset; 101 reference signal source; 102 variable frequency divider; 103 modulator circuit; 104 phase comparator; 105 charge pump; 106 current-output-matching loop filter; 107 voltage-controlled oscillator; 111, 112 D-type flip-flop; 113 AND circuit; 114 power supply circuit; 115 constant-current source; 116, 117 switch; 118 constant-current source; 119 ground terminal.

Claims

1.  A frequency synthesizer including a reference signal source for generating a reference signal, a sync signal output circuit for dividing a high-frequency signal and for outputting a high-frequency signal after division as a sync signal, a phase difference detecting circuit for detecting phase difference between the reference signal generated by the reference signal source and the sync signal output from the sync signal output circuit and for outputting control voltage corresponding to the phase difference, and a voltage-controlled oscillator for generating a high-frequency signal with a frequency corresponding to the control voltage output from the phase difference detecting circuit and for outputting the high-frequency signal to the sync signal output circuit and to an outside, wherein the phase difference detecting circuit comprises:

a first phase comparator for generating a phase difference signal from detection timing of a signal edge of the reference signal and a signal edge of the sync signal;

a first control voltage generating circuit for generating the control voltage corresponding to the phase difference signal generated by the first phase comparator;

a first flip-flop for inverting amplitude of its output signal every time it detects a signal edge of the sync signal;

an inverter for inverting amplitude of the reference signal;

a second flip-flop for inverting amplitude of its output signal every time it detects a signal edge of the reference signal after the amplitude inversion by the inverter;

a second phase comparator for performing an exclusive OR operation for output signals of the first and second flip-flops, and for outputting a phase difference signal indicating the operation result;

a second control voltage generating circuit for generating control voltage corresponding to the phase difference signal output from the second phase comparator;

a sync detecting circuit for detecting establishment of phase sync from the phase difference signal generated by the first phase comparator; and

a control voltage selecting unit for supplying, unless the sync detecting circuit detects the establishment of the phase sync, the control voltage generated by the first control voltage generating circuit to the voltage-controlled oscillator, and for supplying, when the sync detecting circuit detects the establishment of the phase sync, the control voltage generated by the second control voltage generating circuit to the voltage-controlled oscillator.

2. The frequency synthesizer according to claim 1, wherein
the control voltage selecting unit comprises a switch for selecting the control voltage generated by the first control voltage generating circuit or the control voltage generated by the second control voltage generating circuit.

3. The frequency synthesizer according to claim 1, wherein the control voltage selecting unit comprises:

a first switch which is placed at a position on a first signal path from the first phase comparator to an output side of the first control voltage generating circuit and is closed unless the sync detecting circuit detects the establishment of the phase sync;

a second switch which is placed at a position on a second signal path from the second phase comparator to an output side of the second control voltage generating circuit and is closed when the sync detecting circuit detects the establishment of the phase sync; and

an adder circuit for adding the control voltage output from the first signal path and the control voltage output from the second signal path, and for supplying the control voltage after the addition to the voltage-controlled oscillator.

4. The frequency synthesizer according to claim 1, wherein
the first phase comparator has a characteristic of generating the phase difference signal of zero when time difference in detection timing between a signal edge of the reference signal and a signal edge of the sync signal is less than a prescribed value, and where in the control voltage selecting unit comprises:

a switch which is placed at a position on a signal path from the second phase comparator to an output side of the second control voltage generating circuit and is closed when the sync detecting circuit detects the establishment of the phase sync; and

an adder circuit for adding the control voltage generated by the first control voltage generating circuit and the control voltage output from the signal path, and for supplying the control voltage after the addition to the voltage-controlled oscillator.

5. The frequency synthesizer according to claim 1, wherein the first control voltage generating circuit comprises:

a charge pump for outputting a charge pump current corresponding to the phase difference signal generated by the first phase comparator; and

a current-output-matching loop filter for outputting voltage obtained by smoothing the charge pump current output from the charge pump as the control voltage.

**6.** The frequency synthesizer according to claim 1, wherein the first control voltage generating circuit comprises a voltage-output-matching loop filter for outputting voltage obtained by smoothing the phase difference signal generated by the first phase comparator as the control voltage.

**7.** The frequency synthesizer according to claim 1, wherein the sync signal output circuit comprises:

a variable frequency divider for dividing the high-frequency signal output from the voltage-controlled oscillator, and for outputting the high-frequency signal after the division as the sync signal; and
a modulator circuit which operates in sync with the reference signal generated by the reference signal source or with the sync signal output from the variable frequency divider and which controls a number of divisions of the variable frequency divider.

**8.** A frequency synthesizer including a reference signal source for generating a reference signal, a sync signal output circuit for dividing a high-frequency signal and for outputting a high-frequency signal after division as a sync signal, a phase difference detecting circuit for detecting phase difference between the reference signal generated by the reference signal source and the sync signal output from the sync signal output circuit and for outputting control voltage corresponding to the phase difference, and a voltage-controlled oscillator for generating a high-frequency signal with a frequency corresponding to the control voltage output from the phase difference detecting circuit and for outputting the high-frequency signal to the sync signal output circuit and to an outside, wherein the phase difference detecting circuit comprises:

a first phase comparator for generating a phase difference signal from detection timing of a signal edge of the reference signal and a signal edge of the sync signal;
a first flip-flop for inverting amplitude of its output signal every time it detects a signal edge of the sync signal;
an inverter for inverting amplitude of the reference signal;
a second flip-flop for inverting amplitude of its output signal every time it detects a signal edge of the reference signal after the amplitude inversion by the inverter;
a second phase comparator for performing an exclusive OR operation for output signals of the first and second flip-flops, and for outputting a phase difference signal indicating the operation result;
a sync detecting circuit for detecting establishment of phase sync from the phase difference signal generated by the first phase comparator;
a phase difference signal selecting unit for selecting, unless the sync detecting circuit detects the establishment of the phase sync, the phase difference signal generated by the first phase comparator, and for selecting, when the sync detecting circuit detects the establishment of the phase sync, the phase difference signal output from the second phase comparator; and
a control voltage generating circuit for generating the control voltage corresponding to the phase difference signal selected by the phase difference signal selecting unit, and for supplying the control voltage to the voltage-controlled oscillator.

# FIG.1

EP 2 629 424 A1

# FIG.2

# FIG.3

# FIG.4

EP 2 629 424 A1

19

FIG.5

EP 2 629 424 A1

# FIG.6

EP 2 629 424 A1

FIG.7

EP 2 629 424 A1

FIG.8

EP 2 629 424 A1

Sync Signal Output Circuit

12 — Modulator Circuit

11 — ÷N

DIV

2

Output

4

Sync Detecting Circuit — 21

LD

13 — DFF-PD

D

U

31 — Switch

14 — CP

$I_i$

15 — I-LF

$V_{t1}$

33 — Adder Circuit

$V_t$

1 — REF

16 — T-FF

D1

17

18 — T-FF

R1

19 — EX-OR

OUT

OUTB

20 — V-LF

LD

32 — Switch

$V_{t2}$

Phase Difference Detecting Circuit — 3

# FIG.9

EP 2 629 424 A1

# FIG.10

EP 2 629 424 A1

## FIG.11

# FIG.12

Detection Characteristic

Phase Difference

Dead Zone

# FIG.13

EP 2 629 424 A1

# FIG.14

EP 2 629 424 A1

FIG.15

EP 2 629 424 A1

# FIG.16

EP 2 629 424 A1

FIG.17

EP 2 629 424 A1

FIG.18

FIG.19

FIG.20

# FIG.21

# FIG.22

# FIG.23

# FIG.24

# FIG.25

FIG.26

Detection Characteristic

Ideal

Phase Difference

Real

DIV-side Operation ✕ REF-side Operation

(a) Different Slope

Detection Characteristic

Ideal

Phase Difference

Real

Nonlinearity

DIV-side Operation ✕ REF-side Operation

(b) Nonlinear Variation

EP 2 629 424 A1

38

## FIG.27

## FIG.28

**INTERNATIONAL SEARCH REPORT**

| International application No. |
|---|
| PCT/JP2011/002283 |

A.  CLASSIFICATION OF SUBJECT MATTER
*H03L7/087*(2006.01)i, *H03L7/08*(2006.01)i, *H03L7/085*(2006.01)i, *H03L7/095*
(2006.01)i, *H03L7/197*(2006.01)i

According to International Patent Classification (IPC) or to both national classification and IPC

B.  FIELDS SEARCHED

Minimum documentation searched (classification system followed by classification symbols)
H03L7/06-7/23

Documentation searched other than minimum documentation to the extent that such documents are included in the fields searched
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)
CiNii

C.  DOCUMENTS CONSIDERED TO BE RELEVANT

| Category* | Citation of document, with indication, where appropriate, of the relevant passages | Relevant to claim No. |
|---|---|---|
| A | JP 2001-177397 A  (Opnext Inc.),<br>29 June 2001 (29.06.2001),<br>entire text; all drawings<br>& US 6600797 B1        & US 2003/0202804 A1 | 1-8 |
| A | JP 2000-59213 A  (NEC Corp.),<br>25 February 2000 (25.02.2000),<br>entire text; all drawings<br>& US 6442703 B1        & EP 980163 A2<br>& DE 69928050 D        & DE 69928050 T<br>& KR 10-2000-0017276 A | 1-8 |
| A | JP 8-191247 A  (Matsushita Electric Industrial<br>Co., Ltd.),<br>23 July 1996 (23.07.1996),<br>entire text; all drawings<br>(Family: none) | 1-8 |

| ☒ | Further documents are listed in the continuation of Box C. | ☐ | See patent family annex. |

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>06 July, 2011 (06.07.11) | Date of mailing of the international search report<br>19 July, 2011 (19.07.11) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
| --- |
| PCT/JP2011/002283 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | Ken'ichi TAJIMA, "A Low-Noise Fractional-N PLL Synthesizer with DC Offset Adjustment of a Loop Filter", 2008 Nen IEICE Electronics Society Taikai Koen Ronbunshu 1, 17 September 2008 (17.09.2008)(received date), S-72 to S-73 | 1-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TSUNG-HSIEN LIN et al.** Dynamic Current-Matching Charge Pump and Gated-Offset Linearization Technique for Delta-Sigma Fractional-N PLLs. *IEEE Transactions on Circuits and Systems-I,* May 2009, vol. 56 (5), 877-885

- **Y. SUMI et al.** Dead-zone-less PLL Frequency Synthesizer by Hybrid Phase Detectors. *Proceedings of the IEEE Symposium on Circuits and Systems,* June 1999, vol. 4, 410-414